# EUROPEAN PATENT APPLICATION

(11) **EP 4 125 134 A1**
(43) Date of publication of application: **01.02.2023**
(21) Application number: 22187685.7
(22) Date of filing: 29.07.2022
(51) Int. Cl.: H01L 29/66, H01L 29/10, H01L 29/78

(54) **TRANSISTOR STRUCTURE**

(30) Priority: 29.07.2021 US 202163226787 P
(71) Applicant: Invention And Collaboration Laboratory Pte. Ltd., Singapore 068914 (SG)
(72) Inventor: Lu, Chao-Chun, 106 Taipei City (TW)
(74) Representative: Straus, Alexander

(57) **Abstract**

The present invention discloses a transistor structure. The transistor structure includes a substrate, a gate conductive region, a gate dielectric layer, and a sheet channel layer. The substrate has a body region. The gate conductive region is above the body region. The gate dielectric layer is between the gate conductive region and the body region. The sheet channel layer is disposed between the body region and the gate dielectric layer, wherein the sheet channel layer is independent from the substrate. A doping concentration of the body region is higher than a doping concentration of the sheet channel layer.

## Description

### Field of the Invention

The present invention relates to a transistor structure according to claim 1.

### Background of the Invention

In the prior art, there are four metal-oxide-semiconductor field-effect transistor (MOSFET) structures which are widely used and made in volume manufacturing processes: (1) Type A. planar surface-channel MOSFET, (2)Type B. fin field-effect transistor (FinFET) using two vertical sidewalls of a three-dimensional (3D) fin structure as transistor body, (3) Type C. Tri-gate MOSFET using a top surface and two vertical sidewalls of a 3D Fin structure, and (4) Type D. SOI (silicon on insulator) MOSFET which has its transistor body fully isolated from an original bulk silicon wafer substrate.

However, the conventional MOSFET structures have some shortcomings, such as: short channel effect and latch-up problems occurs between N-type metal-oxide-semiconductor (NMOS) transistor and P-type metal-oxide-semiconductor (PMOS); each needs high temperature thermal annealing is required in the manufacture of MOSFET to remove those damages due to heavy bombardments of forming the drain and the source by ion-implantation; the bulk body covered by gate dielectric material is difficult to completely change from depletion to inversion if the heavier doping concentration of the transistor substrate is used to prevent Latch-up problems.

Therefore, how to solve the shortcomings of the above-mentioned four MOSFET structures has become an important issue.

### Summary of the Invention

The present invention aims at providing a transistor structure that can reduce short channel effect and latch-up problems of the transistor structure, and have well-created seamless contact regions between a drain and a channel of the transistor and between a source and the channel of the transistor respectively, and does not need high temperature thermal annealing to remove those damages due to heavy bombardments of forming the drain and the source of the transistor..

This is achieved by a transistor structure according to claim 1. The dependent claims pertain to corresponding further developments and improvements.

As will be seen more clearly from the detailed description following below, the claimed transistor structure. The transistor structure includes a substrate, a gate conductive region, a gate dielectric layer, and a sheet channel layer. The substrate has a body region. The gate conductive region is above the body region. The gate dielectric layer is between the gate conductive region and the body region. The sheet channel layer is disposed between the body region and the gate dielectric layer, wherein the sheet channel layer is independent from the substrate. A doping concentration of the body region is higher than a doping concentration of the sheet channel layer.

According to one aspect of the present invention, the substrate further includes a well region underneath the body region, and the doping concentration of the sheet channel layer is higher than a doping concentration of the well region.

According to one aspect of the present invention, the body region includes a fin structure and the sheet channel layer includes a first sheet channel layer and a second sheet channel layer, the first sheet channel layer contacts to a first sidewall of the fin structure, and the second sheet channel layer contacts to a second sidewall of the fin structure.

According to one aspect of the present invention, the sheet channel layer further includes a third sheet channel layer directly on a top wall of the fin structure.

According to one aspect of the present invention, the transistor further includes a spacer layer, wherein the spacer layer attaches to the first sheet channel layer and the second sheet channel layer.

According to one aspect of the present invention, the spacer layer includes a nitride layer.

According to one aspect of the present invention, the spacer layer only attaches to an upper portion of the first sheet channel layer and an upper portion of the second sheet channel layer.

According to one aspect of the present invention, the first sheet channel layer only contacts to an upper portion of the first side wall of the fin structure, and the second sheet channel layer only contacts to an upper portion of the second side wall of the fin structure.

According to one aspect of the present invention, the transistor further includes a first conductive region, wherein the first conductive region abuts against the sheet channel layer and the body region, and the first conductive region is independent from the substrate.

According to one aspect of the present invention, the first conductive region includes a lightly doped region and a highly doped region vertically stacked on the lightly doped region.

According to one aspect of the present invention, the lightly doped region and the highly doped region are formed by selective growth.

According to one aspect of the present invention, the sheet channel layer is formed by selective growth.

### Brief Description of the Drawings

The present invention is further illustrated by way of example, taking reference to the accompanying drawings thereof:
FIG. 1A is a flowchart illustrating a manufacturing method of a SCBFET according to one embodiment of the present invention,
FIGS. 1B, 1C, 1D, 1E, 1F, 1G, 1H, 11, 1J, 1K, 1L, 1M are diagrams illustrating FIG. 1A, FIG. 2 is a diagram illustrating the pad-nitride layer being deposited and the trench being formed,
FIG. 3 is a diagram illustrating the semiconductor layer being formed by the selective epitaxial growth (SEG) technique,
FIG. 4 is a diagram illustrating the shallow trench isolation (STI) being formed and the gate area across the active region and the isolation region being defined,
FIG. 5 is a diagram illustrating the gate material being formed and the composite layer being deposited,
FIG. 6 is a diagram illustrating the STI being etched and the pad-nitride layer being removed,
FIG. 7 is a diagram illustrating the pad-oxide layer being etched away, some portion of the STI being etched back, and the oxide-2 spacer and the nitride-2 spacer being formed,
FIG. 8 is a diagram illustrating some exposed silicon areas being etched away to create shallow trenches for the source and the drain,
FIG. 9 is a diagram illustrating the oxide-3 layer being thermally grown,
FIG. 10 is a diagram illustrating the oxide-3 layer being etched away,
FIG. 11 is a diagram illustrating the source and the drain being formed by the SEG technique,
FIG. 12 is a diagram illustrating the cross-section of the SCBFET, and Y-direction doping concentration and X-direction doping concentration corresponding to the cross-section of the SCBFET,
FIG. 13 is a diagram illustrating the oxide spacer on the semiconductor layer and the nitride spacer on the oxide spacer being formed,
FIG. 14 is a diagram illustrating the shallow trench isolation (STI) being formed and the gate area across the active region and the isolation region being defined,
FIG. 15 is a diagram illustrating the gate material being formed and the composite layer being deposited,
FIG. 16 is a diagram illustrating the STI being etched and the pad-nitride layer being removed,
FIG. 17 is a diagram illustrating the pad-oxide layer being etched away, some portion of the STI being etched back, and the oxide-2 spacer and the nitride-2 spacer being formed on edges of the gate material and the composite layer,
FIG. 18 is a diagram illustrating some exposed silicon areas being etched away to create shallow trenches for the source and the drain,
FIG. 19 is a diagram illustrating the oxide-3 layer being thermally grown,
FIG. 20 is a diagram illustrating the source and the drain being formed by the SEG technique,
FIG. 21 is a diagram illustrating the cross-section of the SCBFET, and Y-direction doping concentration and X-direction doping concentration corresponding to the cross-section of the SCBFET,
FIG. 22 is a diagram illustrating the semiconductor layer and the STI being formed, the STI being etched back, and the oxide spacer and the nitride spacer being formed,
FIG. 23 is a diagram illustrating the STI oxide-2 being formed and the gate area across the active region and the isolation region being defined,
FIG. 24 is a diagram illustrating the gate material being formed and the composite layer being deposited,
FIG. 25 is a diagram illustrating the STI oxide-2 being etched and the pad-nitride layer being removed,
FIG. 26 is a diagram illustrating the pad-oxide layer being etched away, some portion of the STI oxide-2 being etched back, and the oxide-2 spacer and the nitride-2 spacer being formed,
FIG. 27 is a diagram illustrating some exposed silicon areas being etched away to create shallow trenches for the source and the drain,
FIG. 28 is a diagram illustrating the oxide-3 layer being thermally grown,
FIG. 29 is a diagram illustrating the oxide-3 layer being etched away,
FIG. 30 is a diagram illustrating the source and the drain being formed by the SEG technique,
FIG. 31 is a diagram illustrating the cross-section of the SCBFET, and Y-direction doping concentration and X-direction doping concentration corresponding to the cross-section of the SCBFET,
FIG. 32 is a diagram illustrating the STI being formed,
FIG. 33 is a diagram illustrating the semiconductor layer being formed,
FIG. 34 is a diagram illustrating the STI oxide-2 being formed and the gate area across the active region and the isolation region being defined,
FIG. 35 is a diagram illustrating the gate material being formed and the composite layer being deposited,
FIG. 36 is a diagram illustrating the STI oxide-2 being etched and the pad-nitride layer being removed,
FIG. 37 is a diagram illustrating the pad-oxide layer being etched away, some portion of the STI oxide-2 being etched back, and the oxide-2 spacer and the nitride-2 spacer being formed,
FIG. 38 is a diagram illustrating some exposed silicon areas being etched away to create shallow trenches for the source and the drain,
FIG. 39 is a diagram illustrating the oxide-3 layer being thermally grown,
FIG. 40 is a diagram illustrating the oxide-3 layer being etched away,
FIG. 41 is a diagram illustrating the source and the drain being formed by the SEG technique,
FIG. 42 is a diagram illustrating the cross-section of the SCBFET, and Y-direction doping concentration and X-direction doping concentration corresponding to the cross-section of the SCBFET.

### Detailed Description

The newly invented transistor structure disclosed here is called as a sheet-channel bulk-type MOSFET (with its acronym as SCBFET, new Type B FINFET) which can improve some shortcomings of the above-mentioned four types of transistor structures provided by the prior art, respectively, and presents its own merits especially when the technology needs to scaled even down to 3 nm or below for maximizing transistor's productivity (scalable power-delay product per unit area for low-cost and high yield) in order to satisfy economic demands by continuously following Moore's Law.

For easily describing the SCBFET, some processing methods of accomplishing it will be started first. Both N-type metal-oxide-semiconductor (NMOS) transistor and P-type metal-oxide-semiconductor (PMOS) transistor are needed to achieve complementary MOS (CMOS) circuits but herewith first is an NMOS transistor which is used to illustrate the unique features of the SCBFET, and similar process and structure can be derived for PMOS transistor with just dopant polarity changed based on well-known knowledges popular in silicon CMOS technology. Also, a state-of-the-art FinFET or Tri-gate transistor structure is used for the illustration purpose, which should not be only limited to FinFET or Tri-gate structures.

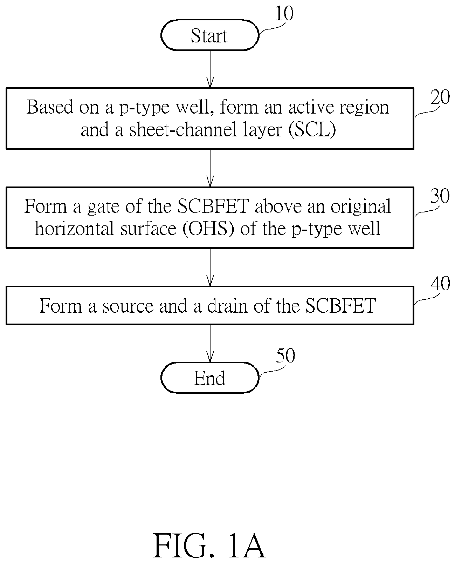

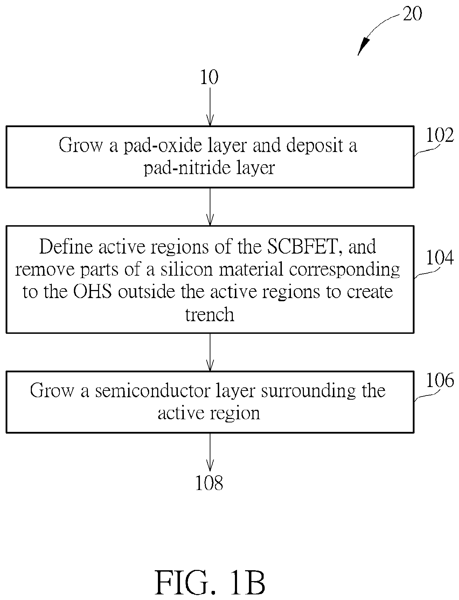

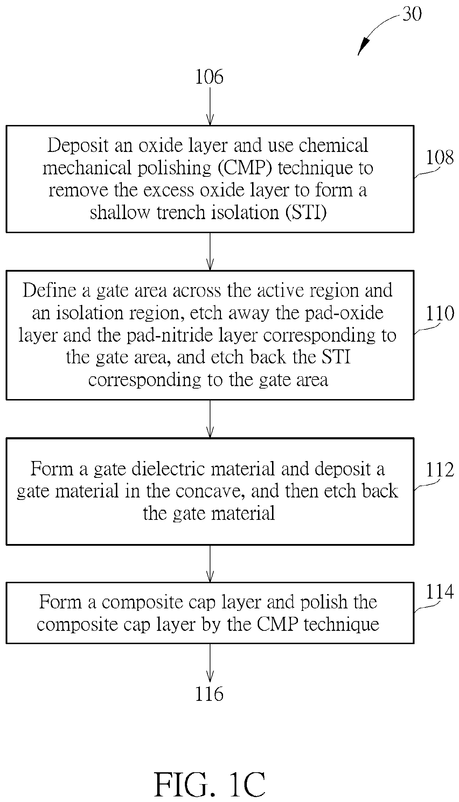

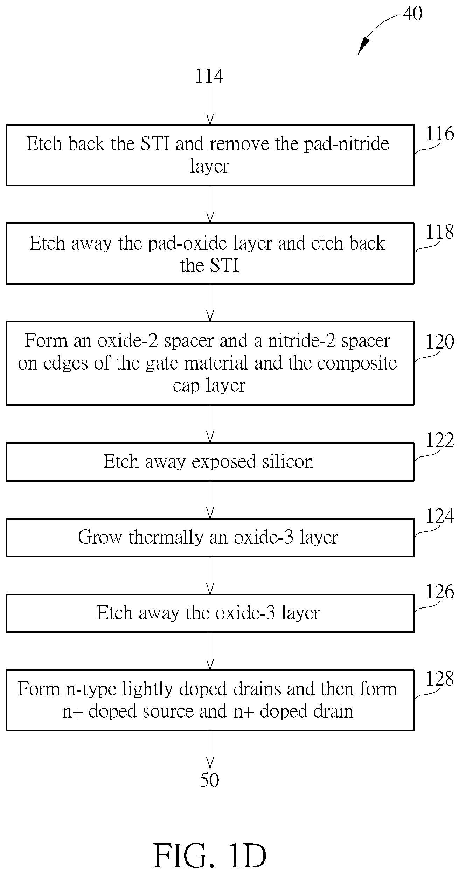

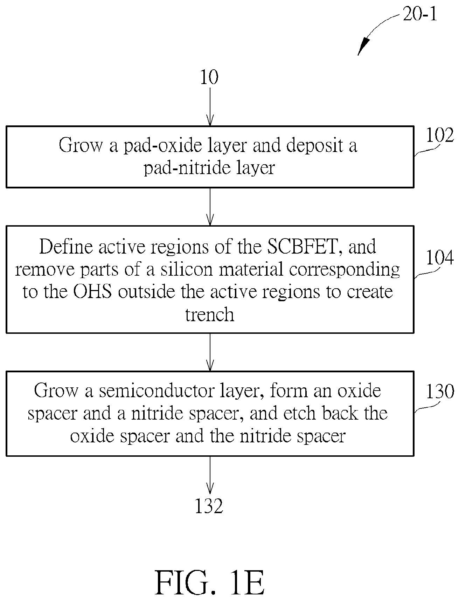

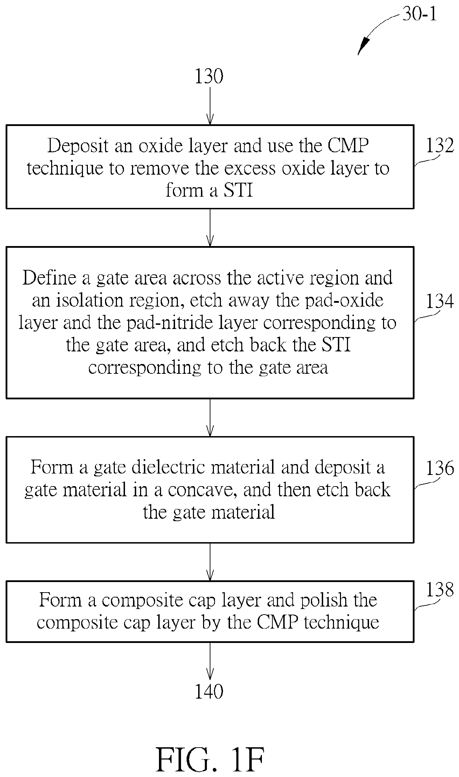

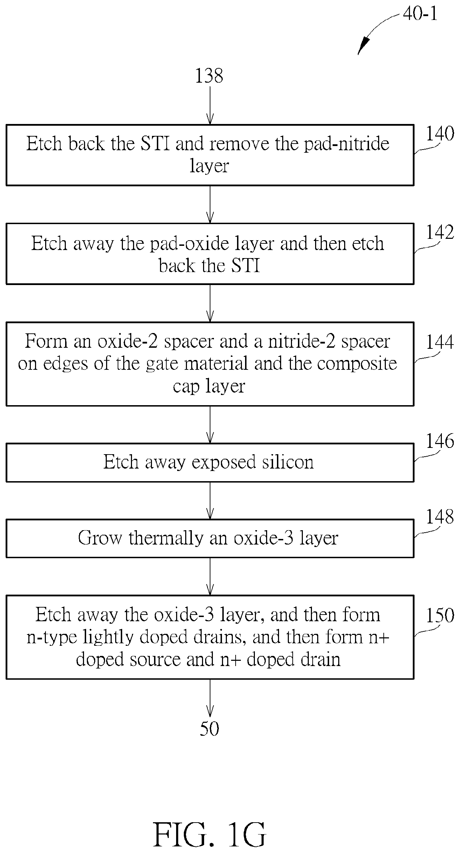

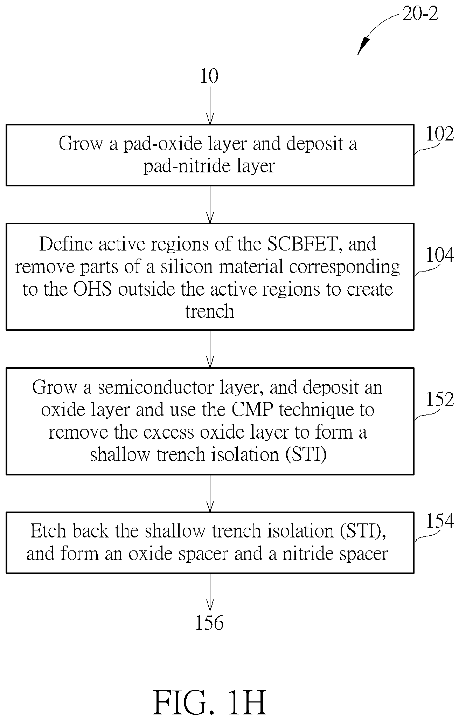

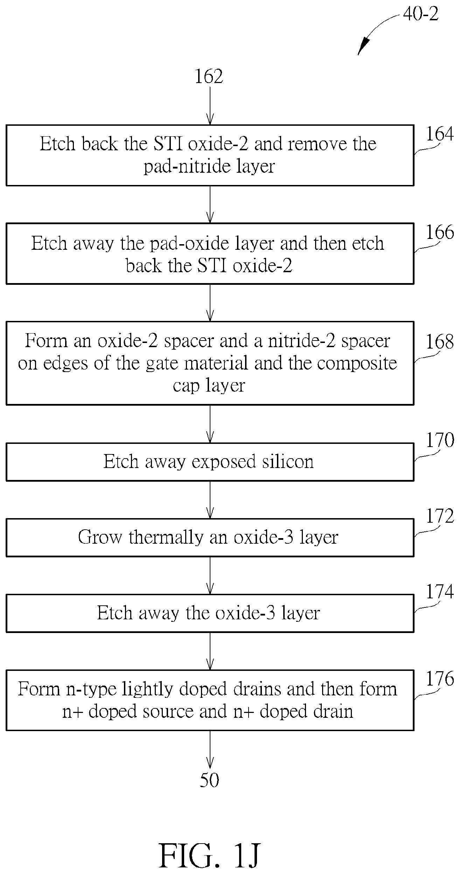

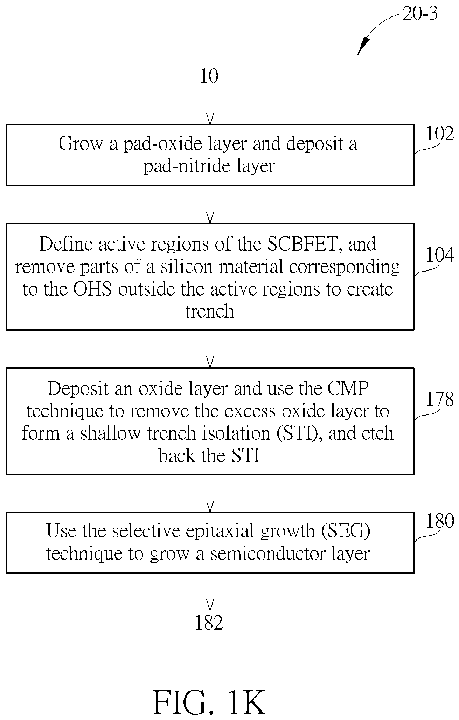

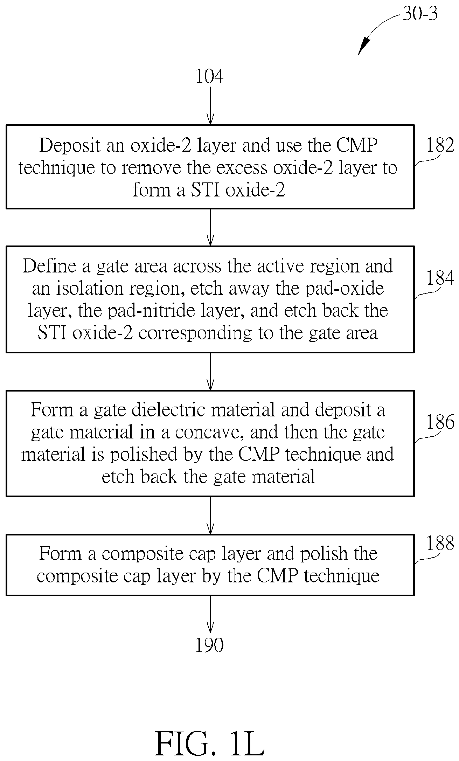

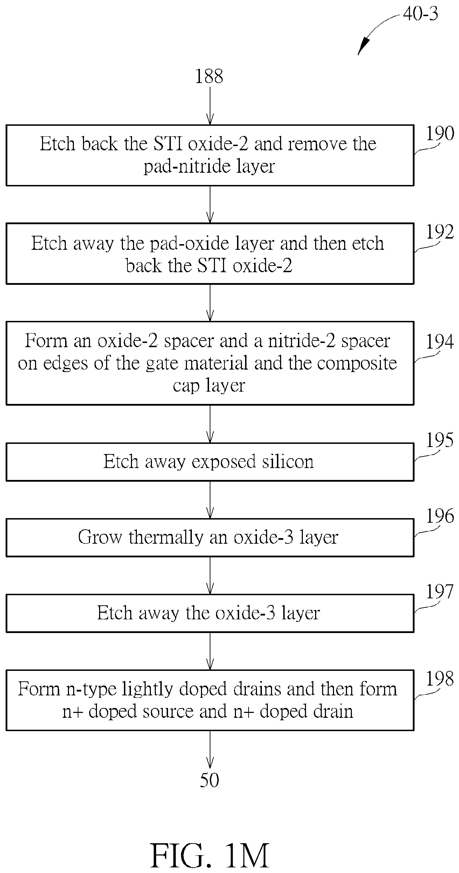

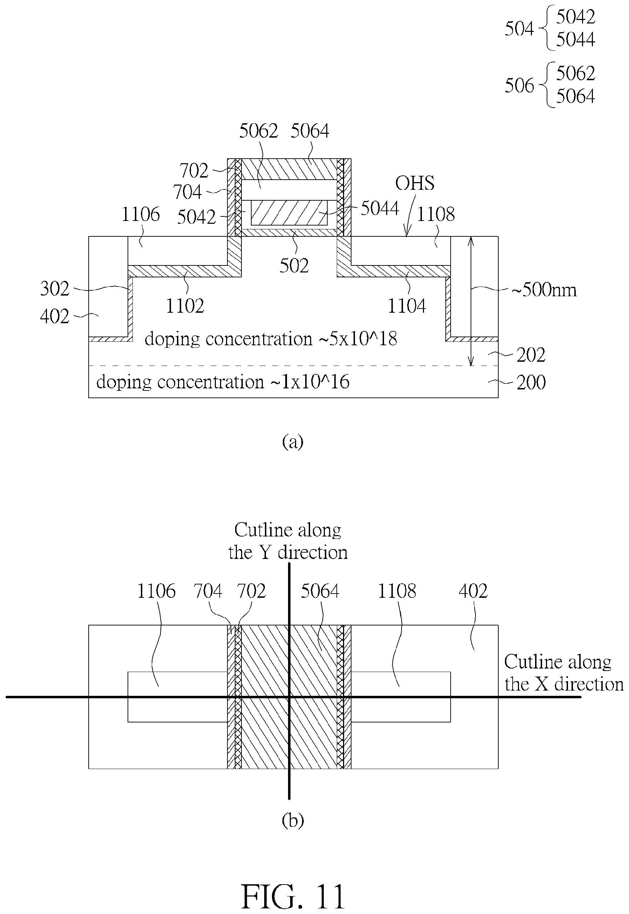

Please refer to FIGS. 1A, 1B, 1C, 1D, 1E, 1F, 1G, 1H, 11, 1J, 1K, 1L, 1M, wherein FIG. 1A is a flowchart illustrating a manufacturing method of a SCBFET according to one embodiment of the present invention, and the manufacturing method of the SCBFET can make the SCBFET have different doping concentration on the fin of the SCBFET. Detailed steps are as follows:

| | |
|---|---|
| Step 10: | Start. |
| Step 20: | Based on a p-type well 202, form an active region and a sheet-channel layer (SCL). |
| Step 30: | Form a gate of the SCBFET above an original horizontal surface (OHS) of the p-type well 202. |
| Step 40: | Form a source and a drain of the SCBFET. |
| Step 50: | End. |

### First embodiment:

Please refer to FIG. 1B and FIGS. 2, 3, Step 20 could include:

| | |
|---|---|
| Step 102: | Grow a pad-oxide layer 204 and deposit a pad-nitride layer 206. |
| Step 104: | Define active regions of the SCBFET, and remove parts of a silicon material corresponding to the OHS outside the active regions to create trench 210. |
| Step 106: | Grow a semiconductor layer 302 surrounding the active region. |

Please refer to FIG. 1C and FIGS. 4, 5. Step 30 could include:

| | |
|---|---|
| Step 108: | Deposit an oxide layer and use chemical mechanical polishing (CMP) technique to remove the excess oxide layer to form a shallow trench isolation (STI) 402. |
| Step 110: | Define a gate area across the active region and an isolation region, etch away the pad-oxide layer 204 and the pad-nitride layer 206 corresponding to the gate area, and etch back the STI 402 corresponding to the gate area. |
| Step 112: | Form a gate dielectric material 502 and deposit a gate material 504 in the concave 404, and then etch back the gate material 504. |
| Step 114: | Form a composite cap layer 506 and polish the composite cap layer 506 by the CMP technique. |

Please refer to FIG. 1D, FIGS. 6, 7, 8, 9, 10, 11, 12. Step 40 could include:

| | |
|---|---|
| Step 116: | Etch back the STI 402 and remove the pad-nitride layer 206. |
| Step 118: | Etch away the pad-oxide layer 204 and etch back the STI 402. |
| Step 120: | Form an oxide-2 spacer 702 and a nitride-2 spacer 704 on edges |
| | of the gate material 504 and the composite cap layer 506. |
| Step 122: | Etch away exposed silicon. |
| Step 124: | Grow thermally an oxide-3 layer 902. |
| Step 126: | Etch away the oxide-3 layer 902. |
| Step 128: | Form n-type lightly doped drains (LDDs) 1102, 1104 and then form n+ doped source 1106 and n+ doped drain 1108. |

Detailed description of the aforesaid manufacturing method is as follows. Start with the well-designed doped p-type well 202, wherein the p-type well 202 is installed in a p-type substrate 200 (wherein in another embodiment of the present invention, could start with the p-type substrate 200, rather than starting with the p-type well 202), wherein the p-type well 202 has its top surface counted down about 500nm thick from the OHS and has higher concentration close to 5×10^18 dopants/cm^3 (for example) than that of being used in state-of-the-art FinFETs having been lighter doped substrate (even including a punch-through implantation dopant profile). In addition, for example, the p-type substrate 200 has lower concentration close to 1×10^16 dopants/cm^3. The actual dopant concentrations will be decided by final mass production optimizations; the key point emphasized here is to ensure that the body of the SCBFET can be kept at its best as a nearly neutral bulk region without being turned into a fully depletion region caused by the gate voltage across the very thin body of the SCBFET. As a result, the p-type substrate voltage (which is usually Grounded, i.e. 0 V) can be supplied across most of the body of the SCBFET, rather than causing mostly depleted Fin substrate (which behaves like a voltage-floated body that is hardly controlled or stabilized, and less desired in contrast to the semiconductor transistor with a voltage stable body).

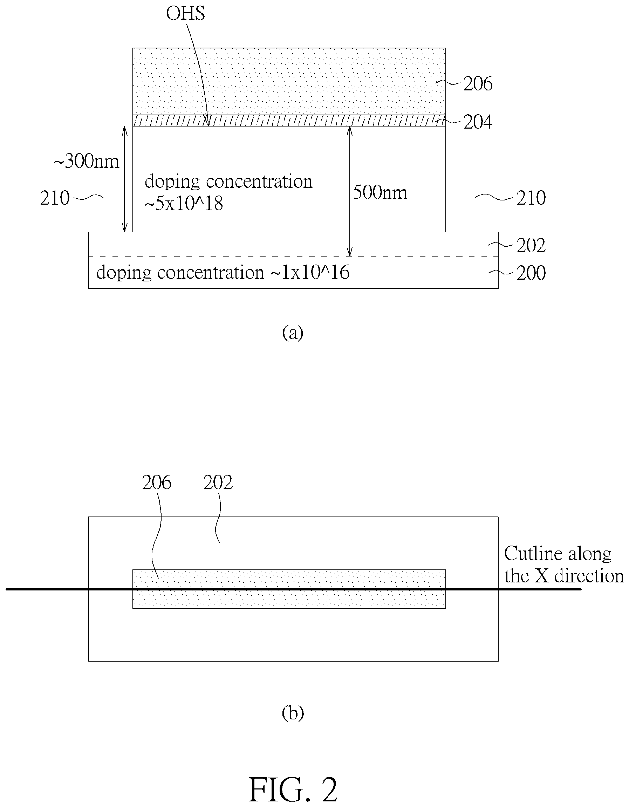

In Step 102, as shown in FIG. 2(a), grow the pad-oxide layer 204 with well-designed thickness over the OHS and deposit the pad-nitride layer 206 with well-designed thickness on a top surface of the pad-oxide layer 204.

In Step 104, as shown in FIG. 2(a), use a photolithographic masking technique to define the active regions of the SCBFET by an anisotropic etching technique, wherein the anisotropic etching technique removes parts of a silicon material corresponding to the OHS outside the active regions to create the trench 210 (e.g. about 300nm deep) for future STI (shallow trench isolation) needs such that the Fin structure of the SCBFET is created. In addition, FIG. 2(b) is a top view corresponding to FIG. 2(a), wherein FIG. 2(a) is a cross-section view along a cutline of an X direction shown in FIG. 2(b).

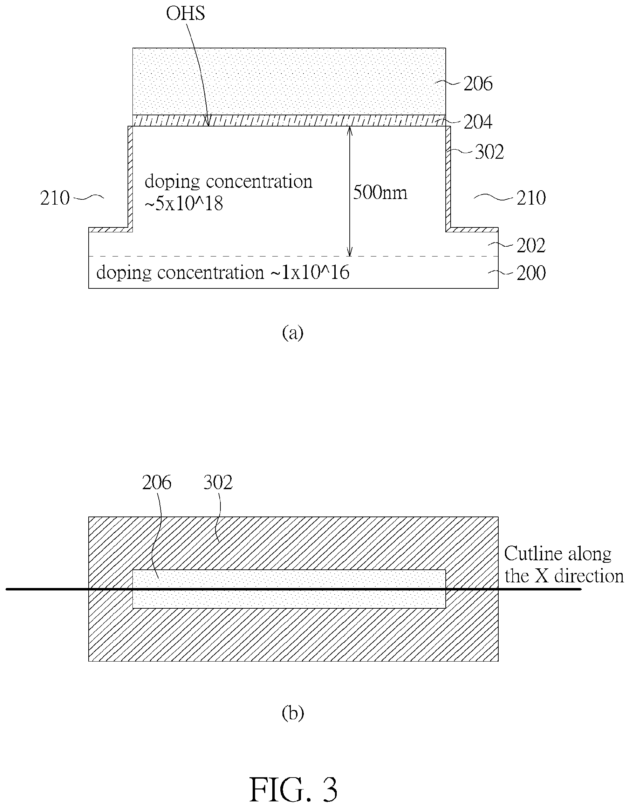

In Step 106, as shown in FIG. 3(a), use a selective growth method, such as selective epitaxial growth (SEG) technique, to grow the semiconductor layer 302 (hereinafter named as sheet-channel layer (SCL), and the SCL could be a monolithic p-type doped silicon about 1 to 2 nm thickness which should be well adjusted for detailed device design) over the exposed silicon surfaces (two sidewalls of the Fin structure and the top surfaces of bottom areas of the trench 210). In addition, FIG. 3(b) is a top view corresponding to FIG. 3(a), wherein FIG. 3(a) is a cross-section view along a cutline of an X direction shown in FIG. 3(b). The key point here is that the semiconductor layer 302 will be used for a channel region (which will be turned into a depleting region until being fully inverted to a channel conduction region which depends upon how the gate voltage is applied) of the SCBFET. So the doping concentration of the semiconductor layer 302 will affect the threshold voltage of the SCBFET and form the major conductive layer with electron carriers under inversion for connecting both the n-type source and n-type drain of the SCBFET. As the semiconductor layer 302 is formed separately from the bulk Fin regions, the most desirable design is to have suitably lower doping concentration (e.g. 1×10^16 to 3×10^18) than that of the Fin body so that the channel conductive condition from OFF to ON changed from depletion to inversion is mostly occurred inside the semiconductor layer 302 with being less affected due to more stable voltage conditions of the bulk body of the Fin. In addition, the semiconductor layer 302 should strengthen the Fin's mechanical stability as the Fin has been proportionally made thinner and taller as the feature size (i.e. dimension of the line) is continued to be scaled down horizontally. The taller Fin can increase the device width (to compensate the reduction of the carrier mobility due to undesirable channel collisions as the Fin becomes narrower) but may cause the physical collapse of some narrow Fins.

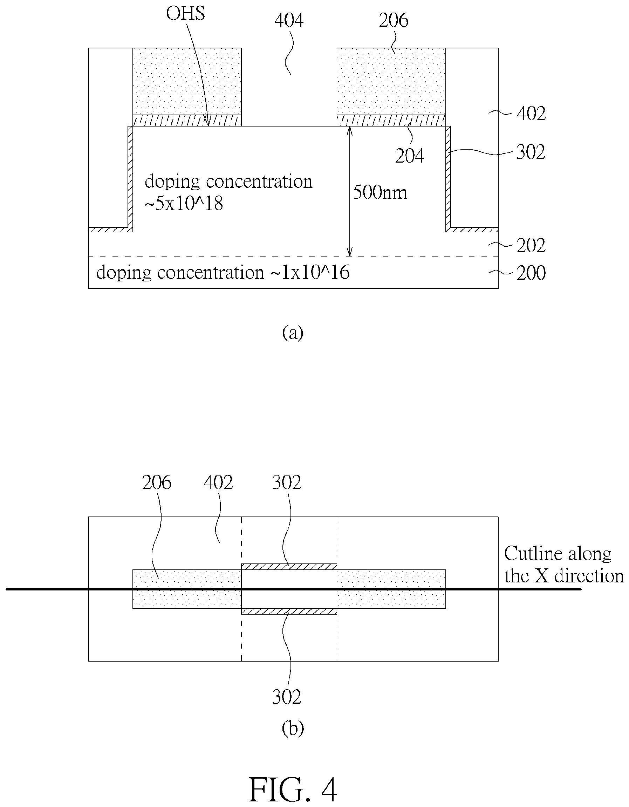

In Step 108, as shown in FIG. 4(a), deposit the thick oxide layer to fully fill the trench 210 and use the CMP technique to remove the excess oxide layer to form the STI 402, wherein a top surface of the STI 402 is in level up to the top surface of the pad-nitride layer 206.

In Step 110, as shown in FIG. 4(a), then use the photolithographic masking technique to define the future gate area across the active region and the isolation region so that both the pad-oxide layer 204 and the pad-nitride layer 206 corresponding to the future gate area are removed to create a concave 404 and the STI 402 corresponding to the future gate area is also removed by a certain amount (e.g. 50nm deep). Thus, the upper portion of the semiconductor layer 302 is exposed. In addition, FIG. 4(b) is a top view corresponding to FIG. 4(a), wherein FIG. 4(a) is a cross-section view along a cutline of an X direction shown in FIG. 4(b).

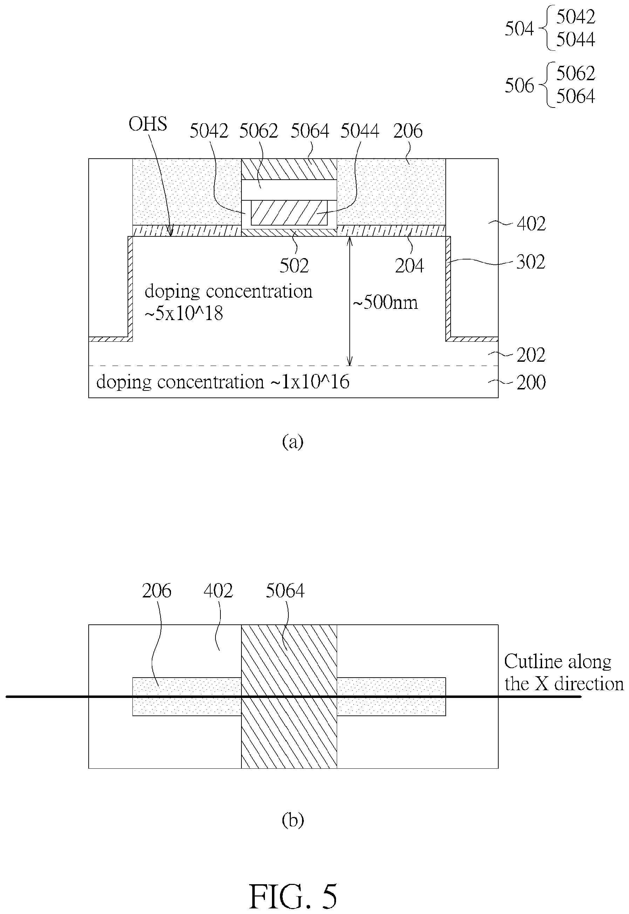

In Step 112, as shown in FIG. 5(a), the gate dielectric material 502 (composite materials or oxide) is formed in the concave 404 and the gate material 504 (e.g. metal like Tungsten 5044 over TiN 5042) is deposited above the gate dielectric material 502. Then the gate material 504 is polished by the CMP technique to make a top surface of the gate material 504 in level up to a top surface of the remained pad-nitride layer 206, and etch back the gate material 504 to make the top surface of the gate material 504 below the top surface of the remained pad-nitride layer 206.

In Step 114, as shown in FIG. 5(a), then deposit the composite cap layer 506 composed of a nitride-1 layer 5062 and a Hardmask-oxide layer 5064 into the concave 404 on the top surface of the gate material 504, wherein the composite cap layer 506 is used for protecting the gate material 504. Then, the composite cap layer 506 is polished by the CMP technique to make a top surface of the composite cap layer 506 in level up to the top surface of the pad-nitride 206. In addition, FIG. 5(b) is a top view corresponding to FIG. 5(a), wherein FIG. 5(a) is a cross-section view along a cutline of an X direction shown in FIG. 5(b).

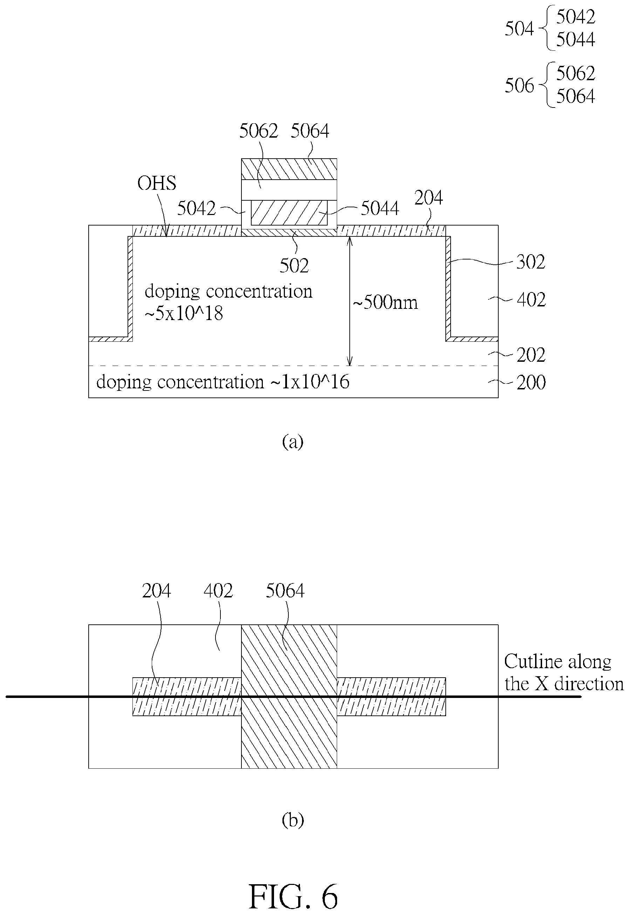

In Step 116, as shown in FIG. 6(a), etch the STI 402 and remove the pad-nitride layer 206 to make a top surface of the STI 402 in level up to the top surface of the pad-oxide layer 204. In addition, FIG. 6(b) is a top view corresponding to FIG. 6(a), wherein FIG. 6(a) is a cross-section view along a cutline of an X direction shown in FIG. 6(b).

Up to Step 116, the two semiconductor layers 302 (sheet-channel layer, SCL) are formed on two sidewalls of the Fin (wherein the two semiconductor layers 302 are named as Qleft and Qright, respectively) but the top surface of the Fin does not have the SCL, so this is the new Type B FinFET (the threshold voltage of the upper MOSFET (Qtop) with higher doping concentrations may be thus higher than those of two sidewall FinFETs). The another embodiment here is to form a Qtop (i.e. forming a SCL on the top area of the Fin). One possible processing method is that before the gate material 504 is patterned (as shown in FIG. 4), remove both the pad-nitride layer 206 and the pad-oxide 204 in a region corresponding to the gate material 504. Then use another SEG to form a thin layer of SCL on the top surface of the Fin (i.e. Qtop). Afterwards, similarly as described in the aforementioned, a thin gate dielectric can be formed at the same time with dielectric formation over the two sidewall SCB layers and the structure is constructed to that described in FIG. 6.

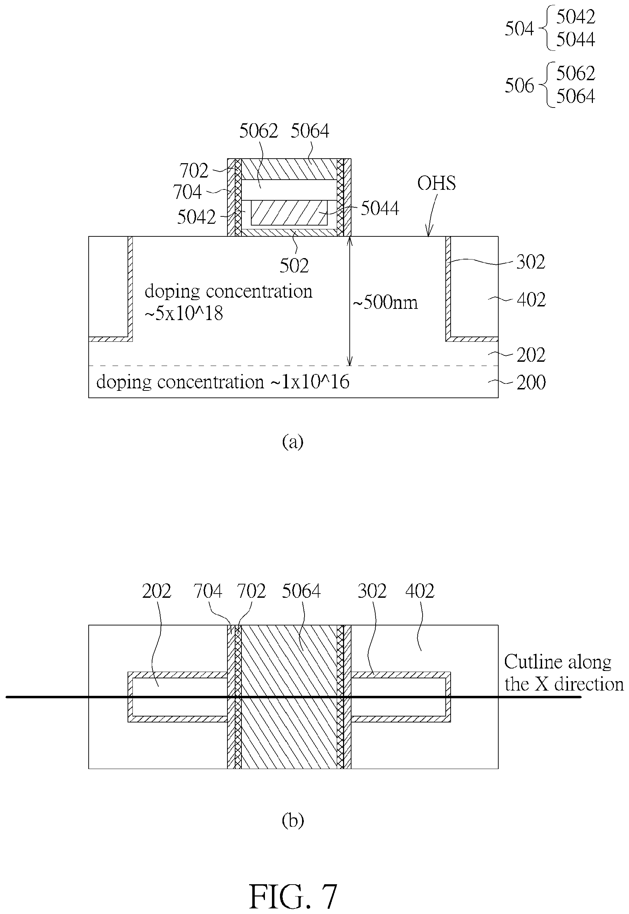

In Step 118, as shown in FIG. 7(a), etch away the pad-oxide layer 204 and etch back some portion of the STI 402.

In Step 120, as shown in FIG. 7(a), then deposit an oxide-2 to form the oxide-2 spacer 702 and a nitride-2 to form the nitride-2 spacer 704 on the edges of the gate material 504 and the composite cap layer 506. In addition, FIG. 7(b) is a top view corresponding to FIG. 7(a), wherein FIG. 7(a) is a cross-section view along a cutline of an X direction shown in FIG. 7(b).

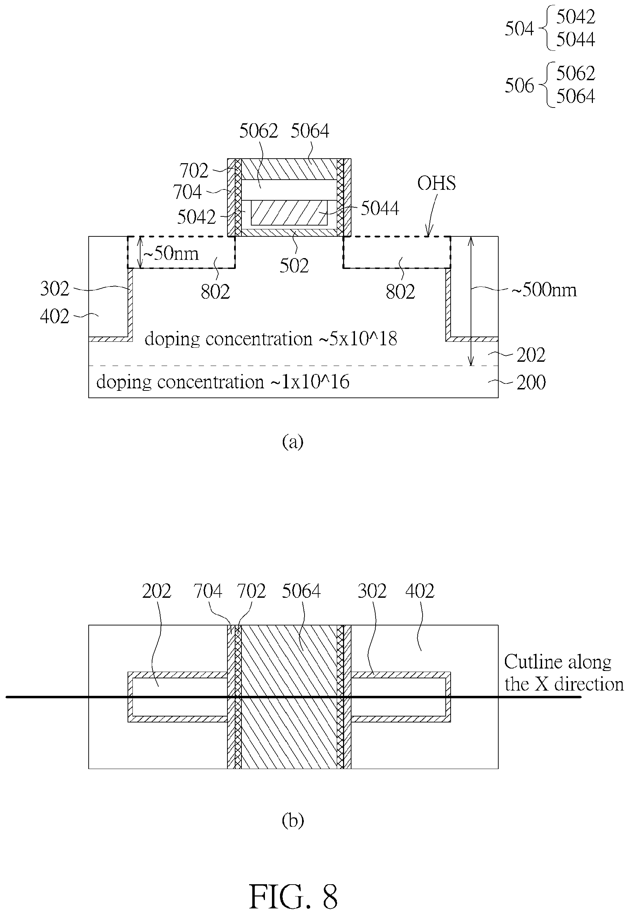

In Step 122, as shown in FIG. 8(a), then etch away some exposed silicon areas to create shallow trenches 802 for the source and the drain (e.g. about 50nm deep) of the SCBFET. In addition, FIG. 8(b) is a top view corresponding to FIG. 8(a), wherein FIG. 8(a) is a cross-section view along a cutline of an X direction shown in FIG. 8(b).

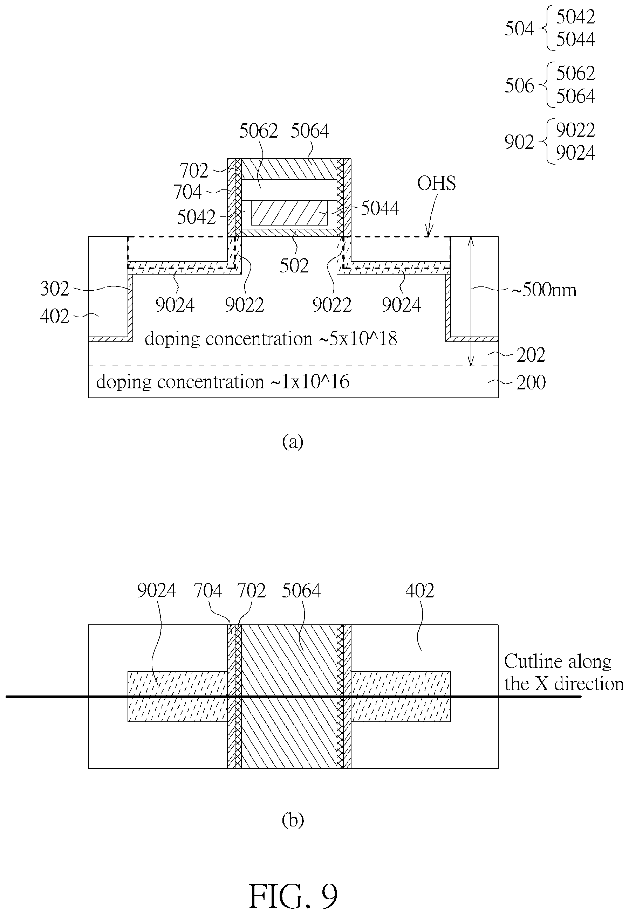

In Step 124, as shown in FIG. 9(a), use a thermal oxidation process, called as oxidation-3 process, to grow the oxide-3 layer 902 (including both oxide-3V layers 9022 penetrating the vertical sidewalls of the SCBFET' body (assuming with a sharp crystalline orientation (110) and oxide-3B layers 9024 on a top surface of bottoms of the shallow trenches 802). Since two sidewalls of the shallow trenches 802 have vertical composite materials of the oxide-2 spacer 702 and the nitride-2 spacer 704, and the other sidewalls of the shallow trenches 802 is against the STI 402, the oxidation-3 process should grow little oxide on these walls such that width of the source/drain of the SCBFET is not really affected. In addition, a thickness of the oxide-3V layer 9022 and the oxide-3B layer 9024 drawn in FIG. 9 and following figures are only shown for illustration purpose, and its geometry is not proportional to the dimension of the STI 402 shown in those figures. For example, the thickness of the oxide-3V layer 9022 and the oxide-3B layer 9024 is around 20~30 nm, but the vertical height of the STI 402 could be around 200~250 nm. In addition, FIG. 9(b) is a top view corresponding to FIG. 9(a), wherein FIG. 9(a) is a cross-section view along a cutline of an X direction shown in FIG. 9(b).

But it is very important to design the oxidation-3 process such that the thickness of oxide-3V layer 9022 can be very accurately controlled under both precisely controlled thermal oxidation temperature, timing and growth rate. Since the thermal oxidation over a well-defined silicon surface should result in that 40% of the thickness of the oxide-3V layer 9022 is taken away the thickness of the exposed (110) silicon surface in the vertical wall of the SCBFET body and the remaining 60% of the thickness of the oxide-3V layer 9022 is counted as an addition outside the vertical wall of the SCBFET body (such a distribution of 40% and 60% on the oxide-3V layer 9022 relative to the oxide-2 spacer 702/the nitride-2 spacer 704 is particularly drawn clearly by dash-lines in FIG. 9 since its importance will be further articulated in the following text).

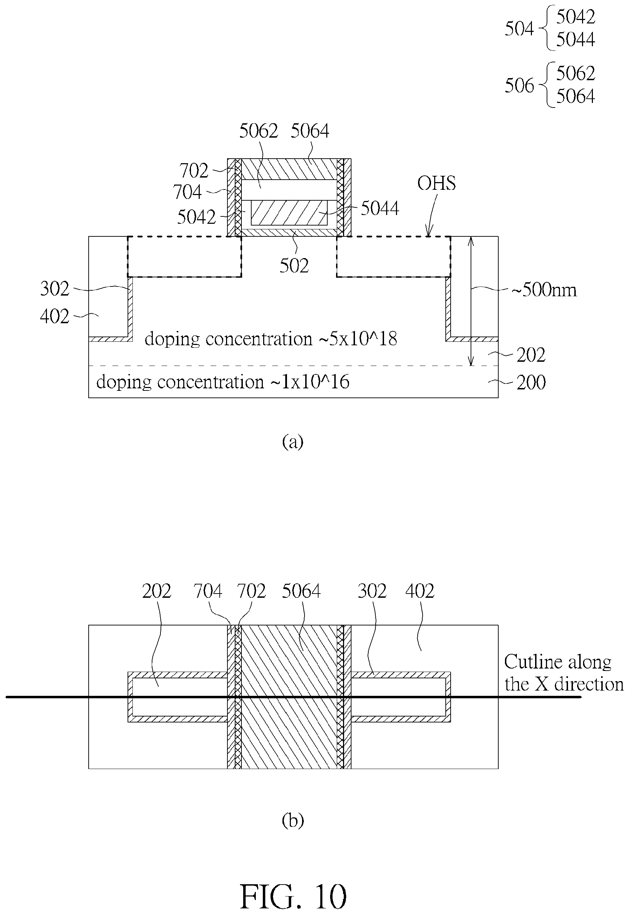

In Step 126, as shown in FIG. 10(a), FIG. 10(a) shows a result after etching away the oxide-3 layer 902. In addition, FIG. 10(b) is a top view corresponding to FIG. 10(a), wherein FIG. 10(a) is a cross-section view along a cutline of an X direction shown in FIG. 10(b).

In Step 128, as shown in FIG. 11(a), then use the selective growth method, such as the SEG technique, to form the n-type LDD 1102, 1104 and then to form the n+ doped source 1106 and the n+ doped drain 1108. Therefore, the major portion of the SCBFET has been completed. In addition, FIG. 11(b) is a top view corresponding to FIG. 11(a), wherein FIG. 11(a) is a cross-section view along a cutline of an X direction shown in FIG. 11(b).

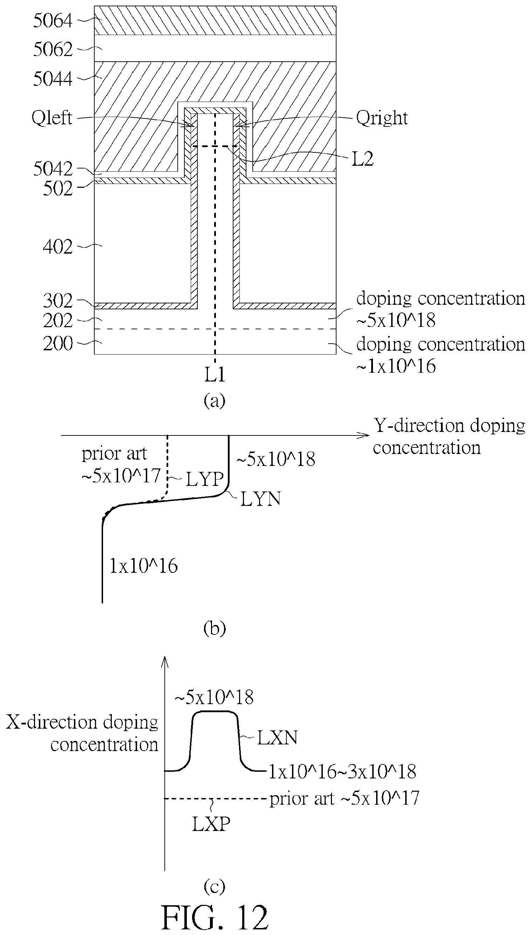

Please refer to FIG. 12. FIG. 12(a) is a cross-section view along a cutline of a Y direction shown in FIG. 11(b). As shown in FIG. 12(a), on the cross-section view, it's clear to see both the Qleft and the Qright which are SEG grown p-type doped silicon channel region. As shown in FIG. 12(b), there are Y-direction concentration profile LYN and Y-direction concentration profile LYP of the prior art, wherein the Y-direction concentration profile LYN corresponds to a dash line L1 marked in FIG. 12(a). Similarly, as shown in FIG. 12(c), there is X-direction concentration profile LXN and X-direction concentration profile LXP of the prior art, wherein the X-direction concentration profile LXN corresponds to a dash line L2 marked in FIG. 12(a). It is clear that the doping concentration of the Qleft and the Qright (e.g. 1×10^16 to 3×10^18) is lower than that (e.g. 5×10^18) of the Fin body. The major invention points are described in the following. Since both the drain and the source of the SCBFET are formed by the SEG technique except they are doped with n-type dopants in concentrations higher than that of the Qleft and the Qright, both well-created seamless contact regions between the drain and the channel and between the source and the channel, respectively, have been well formed. No ion-implantations for forming all channels, the drain and the source are completed and no high temperature thermal annealing is necessary to remove those damages due to heavy bombardments of forming the drain and the source. In addition, since the doping concentration of the Qleft and the Qright is lower than that of the bulk body of the SCBFET, it is expected that the threshold voltage be sharply defined by the well-designed work-function of the metal-oxide-SCL structure especially if the concentration of the bulk body is higher and harder to be inverted and a well-defined body voltage (such as Ground) can stabilize the SCBFET function. Then it's believed that the short channel effect of the SCBFET is greatly improved. Moreover, due to heavier doping concentration is used for the SCBFET, the latch-up problems occurring between NMOS and PMOS can also greatly improved.

### Second embodiment:

In the following, the second embodiment to create a SCBFET is illustrated, wherein the second embodiment includes Step 10, Step 20-1, Step 30-1, Step 40-1, Step 50.

Please refer to FIG. 1E and FIGS 2, 3, 13, Step 20-1 could include:

| | |
|---|---|
| Step 102: | Grow a pad-oxide layer 204 and deposit a pad-nitride layer 206. |
| Step 104: | Define active regions of the SCBFET, and remove parts of a silicon material corresponding to the OHS outside the active regions to create trench 210. |
| Step 130: | Grow a semiconductor layer 302, form an oxide spacer 1302 and a |
| | nitride spacer 1304, and etch back the oxide spacer 1302 and the nitride spacer 1304. |

Then, please refer to FIG. 1F and FIGS. 14, 15. Step 30-1 could include:

| | |
|---|---|
| Step 132: | Deposit an oxide layer and use the CMP technique to remove the excess oxide layer to form a STI 402. |
| Step 134: | Define a gate area across the active region and an isolation region, etch away the pad-oxide layer 204 and the pad-nitride layer 206 corresponding to the gate area, and etch back the STI 402 corresponding to the gate area. |
| Step 136: | Form a gate dielectric material 502 and deposit a gate material 504 in a concave 404, and then etch back the gate material 504. |
| Step 138: | Form a composite cap layer 506 and polish the composite cap layer 506 by the CMP technique. |

Please refer to FIGS. 1G, 16, 17, 18, 19, 20, 21. Step 40-1 could include:

| | |
|---|---|
| Step 140: | Etch back the STI 402 and remove the pad-nitride layer 206. |
| Step 142: | Etch away the pad-oxide layer 204 and then etch back the STI 402. |
| Step 144: | Form an oxide-2 spacer 702 and a nitride-2 spacer 704 on edges of the gate material 504 and the composite cap layer 506. |
| Step 146: | Etch away exposed silicon. |
| Step 148: | Grow thermally an oxide-3 layer 902. |
| Step 150: | Etch away the oxide-3 layer 902, and then form n-type lightly doped drains (LDDs) 1102, 1104, and then form n+ doped source 1106 and n+ doped drain 1108. |

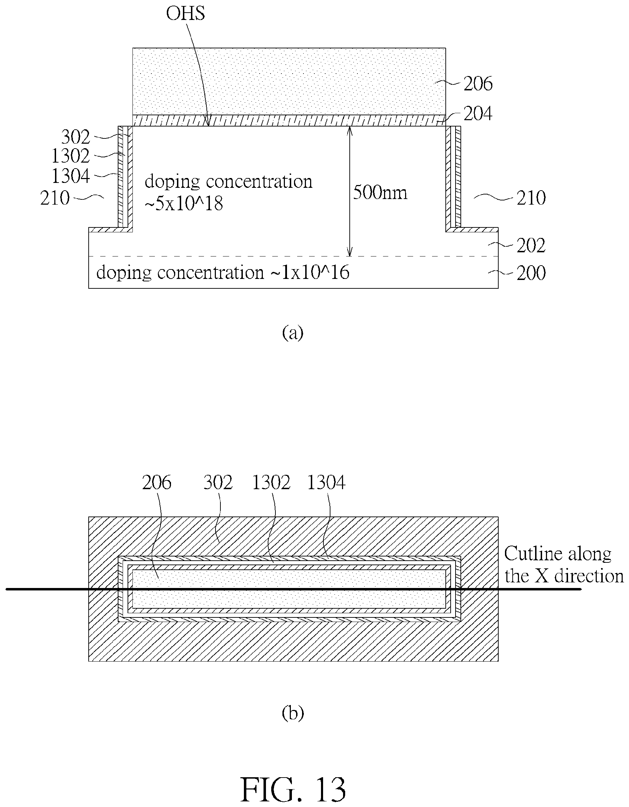

In Step 130, as shown in FIG. 13(a), differences between Step 106 and Step 130 are that form the oxide spacer 1302 on the semiconductor layer 302 and form the nitride spacer 1304 on the oxide spacer 1302, and use the anisotropic etching technique to etch back the oxide spacer 1302 and the nitride spacer 1304 to make top surfaces of the oxide spacer 1302 and the nitride spacer 1304 are in level up to the OHS, wherein the oxide spacer 1302 and the nitride spacer 1304 are outside the active region of the SCBFET. The key point here is that the semiconductor layer 302 will be used for the channel region (which will be turned into a depleting region until being fully inverted to a channel conduction region which depends upon how the gate voltage is applied) of the SCBFET. So the doping concentration of the semiconductor layer 302 will affect the threshold voltage of the SCBFET and form the major conductive layer with electron carriers under inversion for connecting both the n-type source and drain regions. As the semiconductor layer 302 is formed separately from the bulk Fin regions, the most desirable design is to have suitably lower doping concentration (e.g. 1×10^16 to 3×10^18) than that of the Fin body so that the channel conductive condition from OFF to ON changed from depletion to inversion is mostly occurred inside the semiconductor layer 302 with being less affected due to more stable voltage conditions of the bulk body of the Fin. In addition, the semiconductor layer 302 plus the nitride spacer 1304 and the oxide spacer 1302 should strengthen the Fin's mechanical stability as the Fin has been proportionally made thinner and taller as the feature size (i.e. dimension of the line) is continued to be scaled down horizontally. The taller Fin can increase the device width (to compensate the reduction of the carrier mobility due to undesirable channel collisions as the Fin becomes narrower) but may cause the physical collapse of some narrow Fins. In addition, FIG. 13(b) is a top view corresponding to FIG. 13(a), wherein FIG. 13(a) is a cross-section view along a cutline of an X direction shown in FIG. 13(b).

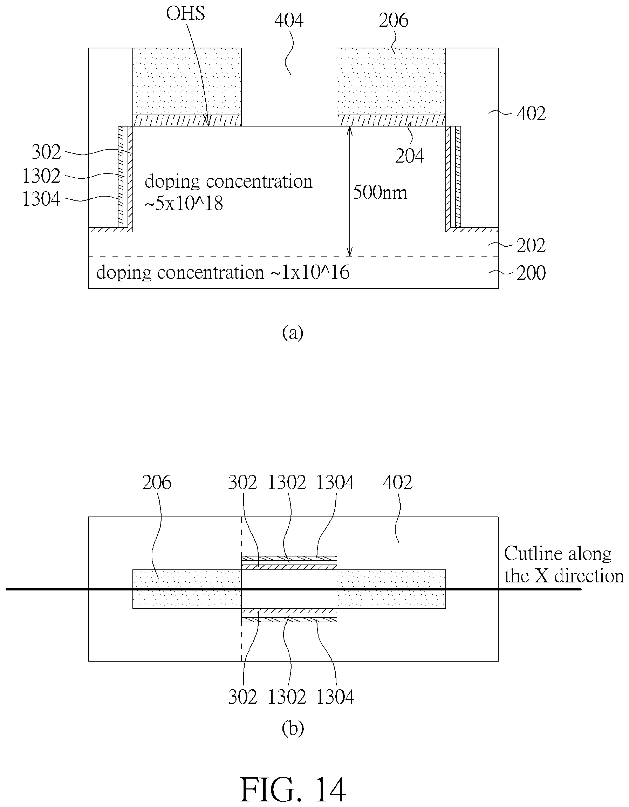

Step 132 (corresponding to FIG. 14) is the same as Step 108, so further description thereof is omitted for simplicity.

In Step 134, as shown in FIG. 14(a), then use the photolithographic masking technique to define the future gate area across the active region and the isolation region so that the pad-oxide layer 204 and the pad-nitride layer 206 corresponding to the gate area are removed to create the concave 404. Moreover, the STI 402 corresponding to the future gate area is also removed by a certain amount (e.g. 50nm deep). Thus, upper portions of the semiconductor layer 302, the oxide spacer 1302, and the nitride spacer 1304 are exposed. In addition, FIG. 14(b) is a top view corresponding to FIG. 14(a), wherein FIG. 14(a) is a cross-section view along a cutline of an X direction shown in FIG. 14(b).

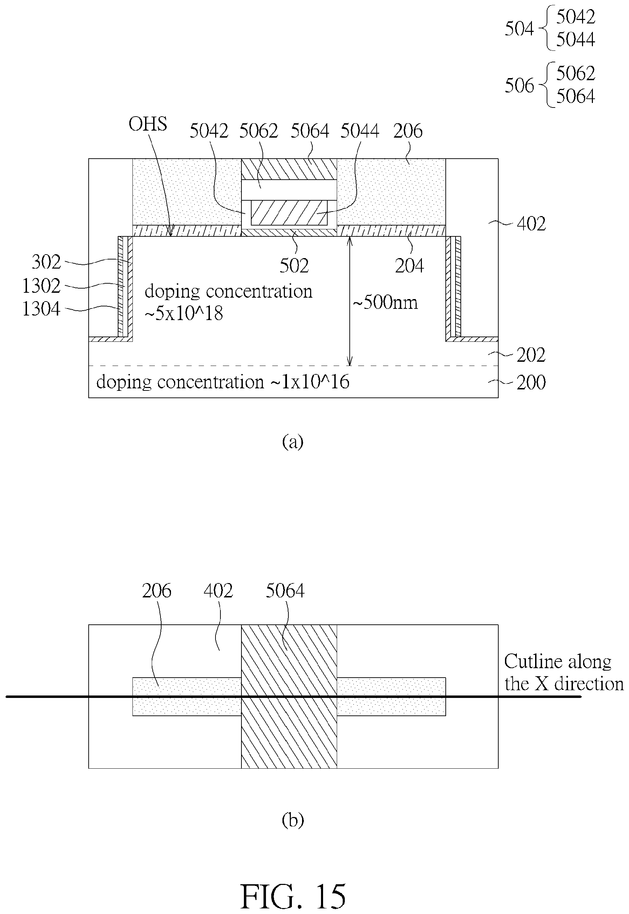

Step 136 and Step 138 (corresponding to FIG. 15) are the same as Step 112 and Step 114, respectively, so further description thereof is omitted for simplicity. In addition, FIG. 15(b) is a top view corresponding to FIG. 15(a), wherein FIG. 15(a) is a cross-section view along a cutline of an X direction shown in FIG. 15(b).

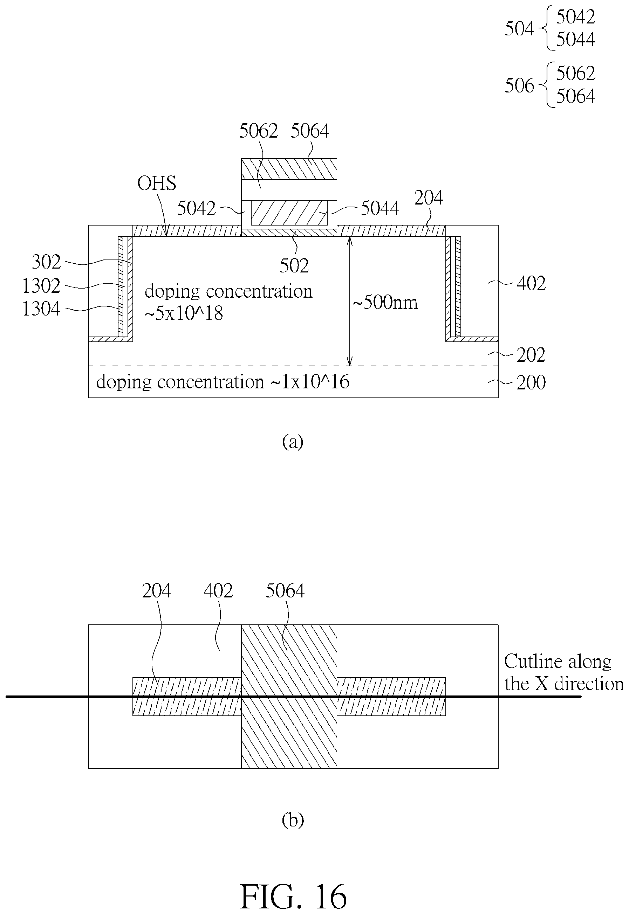

Step 140 (corresponding to FIG. 16) is the same as Step 116, so further description thereof is omitted for simplicity. In addition, FIG. 16(b) is a top view corresponding to FIG. 16(a), wherein FIG. 16(a) is a cross-section view along a cutline of an X direction shown in FIG. 16(b).

Similarly, up to Step 140, the two semiconductor layers 302 (sheet-channel layer, SCL) are formed on two sidewalls of the Fin (wherein the two semiconductor layers 302 are named as Qleft and Qright, respectively) but the top surface of the Fin does not have the SCL, so this is the new Type B FinFET (the threshold voltage of the upper MOSFET (Qtop) with higher doping concentrations may be thus higher than those of two sidewall FinFETs). The another embodiment here is to form a Qtop (i.e. forming a SCL on the top area of the Fin). One possible processing method is that before the gate material 504 is patterned (as shown in FIG. 14), remove both the pad-nitride layer 206 and the pad-oxide 204 in a region corresponding to the gate material 504. Then use another SEG to form a thin layer of SCL on the top surface of the Fin (i.e. Qtop). Afterwards, similarly as described in the aforementioned, a thin gate dielectric can be formed at the same time with dielectric formation over the two sidewall SCB layers and the structure is constructed to that described in FIG. 16.

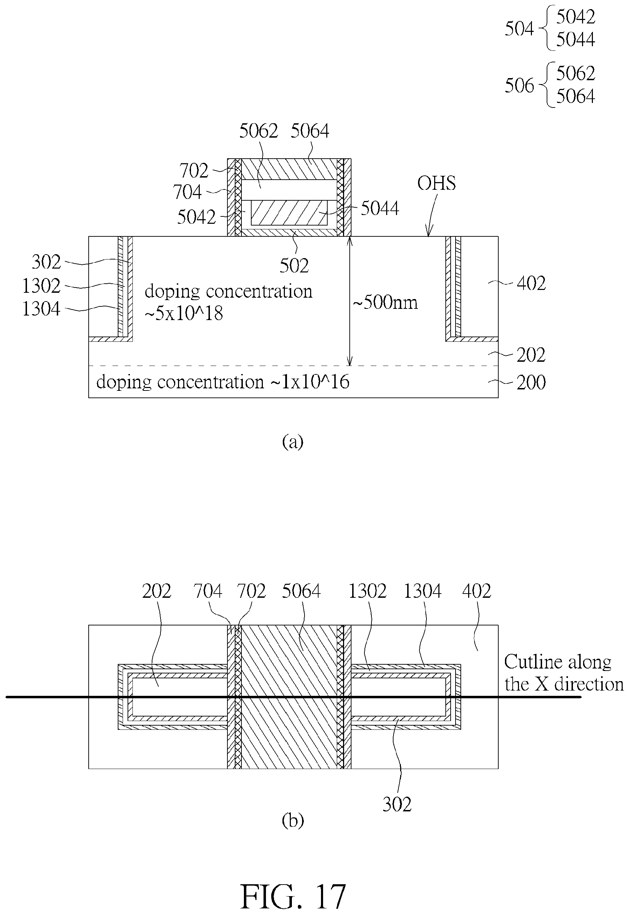

Step 142 and Step 144 (corresponding to FIG. 17) are the same as Step 118 and Step 120, respectively, so further description thereof is omitted for simplicity. In addition, FIG. 17(b) is a top view corresponding to FIG. 17(a), wherein FIG. 17(a) is a cross-section view along a cutline of an X direction shown in FIG. 17(b).

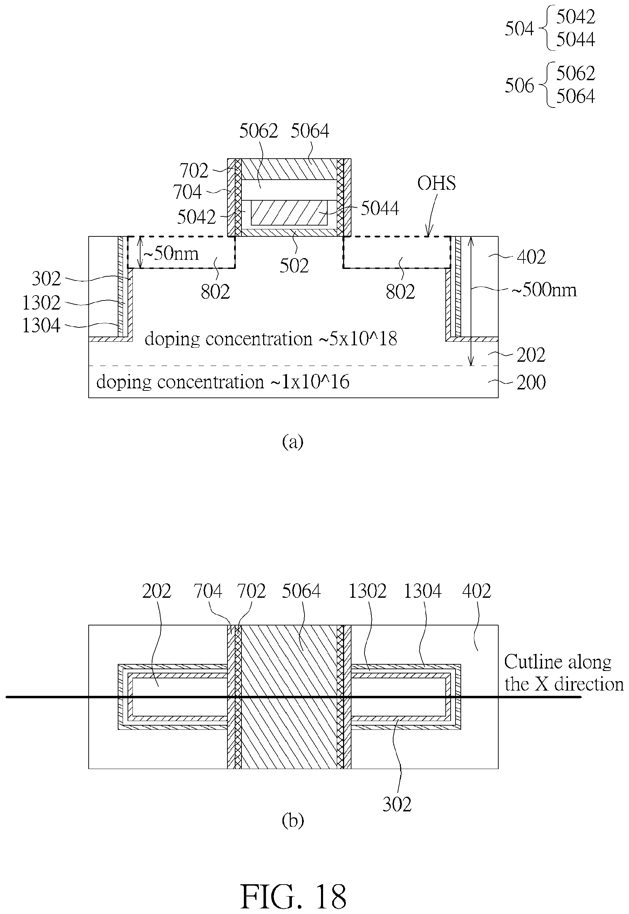

Step 146 (corresponding to FIG. 18) is the same as Step 122, so further description thereof is omitted for simplicity. In addition, FIG. 18(b) is a top view corresponding to FIG. 18(a), wherein FIG. 18(a) is a cross-section view along a cutline of an X direction shown in FIG. 18(b).

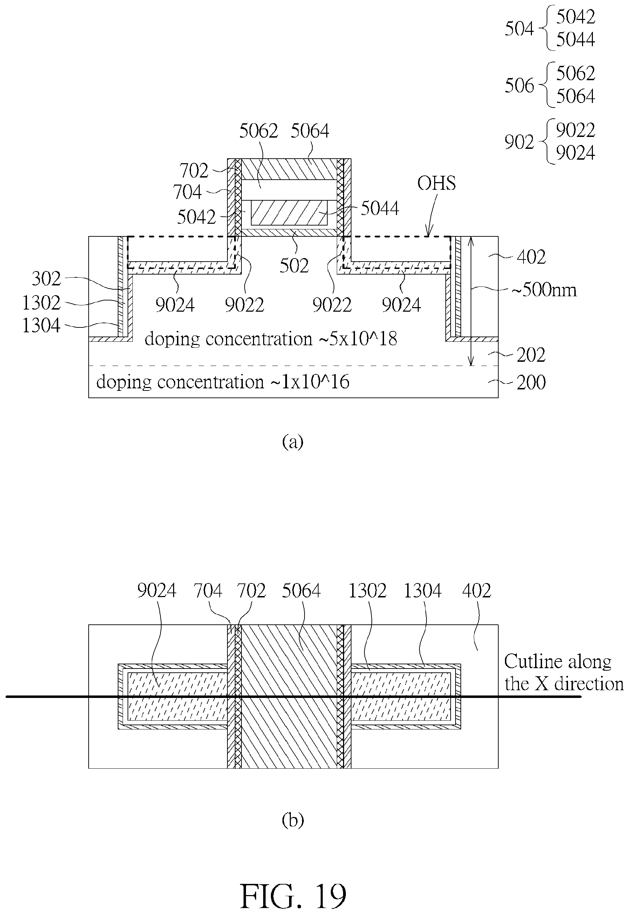

In Step 148, as shown in FIG. 19(a), use the thermal oxidation process, called as the oxidation-3 process, to grow the oxide-3 layer 902 (including both the oxide-3V layers 9022 penetrating the vertical sidewalls of the SCBFET' body (assuming with a sharp crystalline orientation (110)) and the oxide-3B layers 9024 on the top surface of the bottoms of the shallow trenches 802. Since two sidewalls of the shallow trenches 802 have vertical composite materials of the oxide-2 spacer 702 and the nitride-2 spacer 704, and the other sidewalls of the shallow trenches 802 is against the oxide spacer 1302 and the nitride spacer 1304, the oxidation-3 process should grow little oxide on these walls such that width of the source/drain of the SCBFET is not really affected. In addition, the thickness of the oxide-3V layer 9022 and the oxide-3B layer 9024 drawn in FIG. 19 and following figures are only shown for illustration purpose, and its geometry is not proportional to the dimension of the STI 402 shown in those figures. For example, the thickness of the oxide-3V layer 9022 and the oxide-3B layer 9024 is around 20~30 nm, but the vertical height of the STI 402 could be around 200~250 nm. In addition, subsequent descriptions of Step 148 can be referred to corresponding descriptions of FIG. 9, so further description thereof is omitted for simplicity. In addition, FIG. 19(b) is a top view corresponding to FIG. 19(a), wherein FIG. 19(a) is a cross-section view along a cutline of an X direction shown in FIG. 19(b).

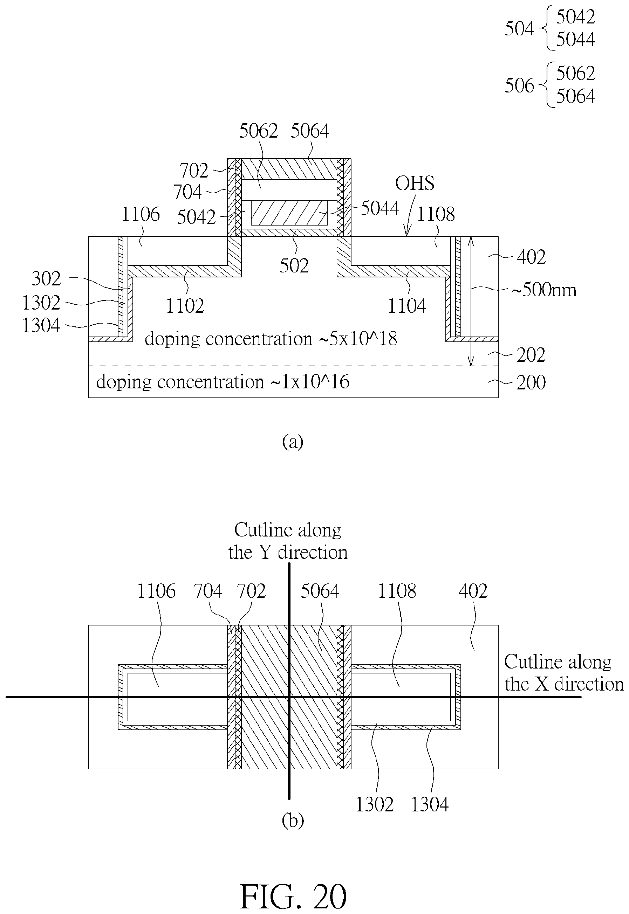

Step 150 (corresponding to FIG. 20) can be referred to Step 126 and Step 128, so further description thereof is omitted for simplicity. In addition, the major portion of the SCBFET has been completed. In addition, FIG. 20(b) is a top view corresponding to FIG. 20(a), wherein FIG. 20(a) is a cross-section view along a cutline of an X direction shown in FIG. 20(b).

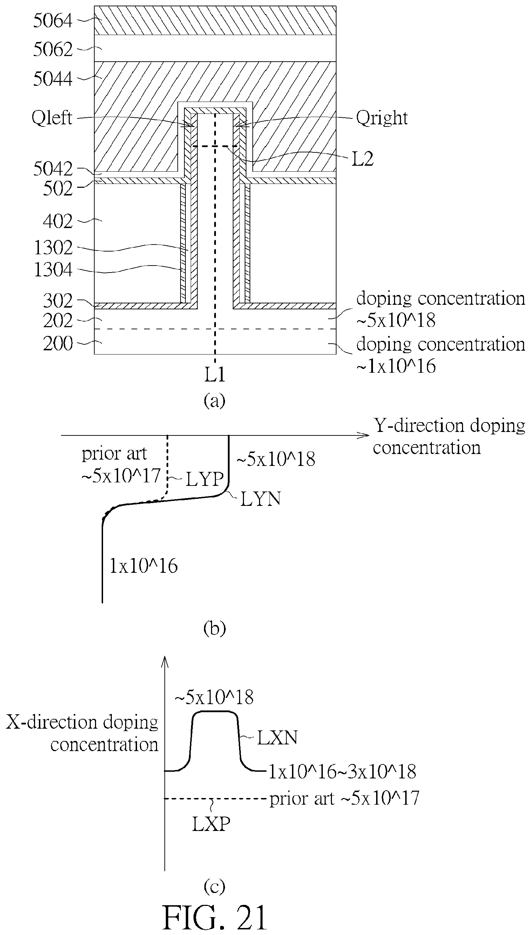

Please refer FIG. 21. FIG. 21(a) is a cross-section view along a cutline of a Y direction shown in FIG. 20(b). As shown in FIG. 21(a), on the cross-section view, it's clear to see both the Qleft and the Qright which are SEG grown p-type doped silicon channel region. As shown in FIG. 21(b), there is Y-direction concentration profile LYN and Y-direction concentration profile LYP of the prior art, wherein the Y-direction concentration profile LYN corresponds to a dash line L1 marked in FIG. 21(a). Similarly, as shown in FIG. 21(c), there is X-direction concentration profile LXN and X-direction concentration profile LXP of the prior art, wherein the X-direction concentration profile LXN corresponds to a dash line L2 marked in FIG. 21(a). In addition, subsequent descriptions of FIG. 21 can be referred to corresponding descriptions of FIG. 12, so further description thereof is omitted for simplicity.

### Third embodiment:

In the following, the third embodiment to create a SCBFET is illustrated, wherein the third embodiment includes Step 10, Step 20-2, Step 30-2, Step 40-2, Step 50.

Please refer to FIG. 1H and FIGS 2, 3, 22, Step 20-2 could include:

| | |
|---|---|
| Step 102: | Grow a pad-oxide layer 204 and deposit a pad-nitride layer 206. |
| Step 104: | Define active regions of the SCBFET, and remove parts of a silicon material corresponding to the OHS outside the active regions to create trench 210. |
| Step 152: | Grow a semiconductor layer 302, and deposit an oxide layer and use the CMP technique to remove the excess oxide layer to form a shallow trench isolation (STI) 402. |
| Step 154: | Etch back the shallow trench isolation (STI) 402, and form an oxide spacer 2202 and a nitride spacer 2204. |

The semiconductor layer 302 plus the oxide spacer 2202 and the nitride spacer 2204 should strengthen the Fin's mechanical stability as the Fin has been proportionally made thinner and taller as the feature size (i.e. dimension of the line) is continued to be scaled down horizontally.

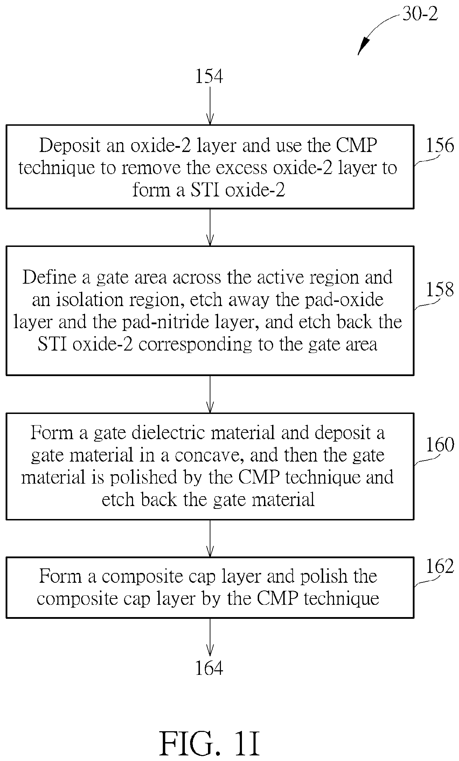

Then, please refer to FIG. 1I and FIGS. 23, 24. Step 30-2 could include:

| | |
|---|---|
| Step 156: | Deposit an oxide-2 layer and use the CMP technique to remove the excess oxide-2 layer to form a STI oxide-2 2302. |
| Step 158: | Define a gate area across the active region and an isolation region, etch away the pad-oxide layer 204 and the pad-nitride layer 206, and etch back the STI oxide-2 2302 corresponding to the gate area. |
| Step 160: | Form a gate dielectric material 502 and deposit a gate material 504 in a concave 404, and then the gate material 504 is polished by the CMP technique and etch back the gate material 504. |
| Step 162: | Form a composite cap layer 506 and polish the composite cap layer 506 by the CMP technique. |

Please refer to FIG. 1J, FIGS. 25, 26, 27, 28, 29, 30, 31. Step 40-2 could include:

| | |
|---|---|
| Step 164: | Etch back the STI oxide-2 2302 and remove the pad-nitride layer 206. |
| Step 166: | Etch away the pad-oxide layer 204 and then etch back the STI oxide-2 2302. |
| Step 168: | Form an oxide-2 spacer 702 and a nitride-2 spacer 704 on edges of the gate material 504 and the composite cap layer 506. |
| Step 170: | Etch away exposed silicon. |
| Step 172: | Grow thermally an oxide-3 layer 902. |
| Step 174: | Etch away the oxide-3 layer 902. |
| Step 176: | Form n-type lightly doped drains (LDDs) 1102, 1104 and then form n+ doped source 1106 and n+ doped drain 1108. |

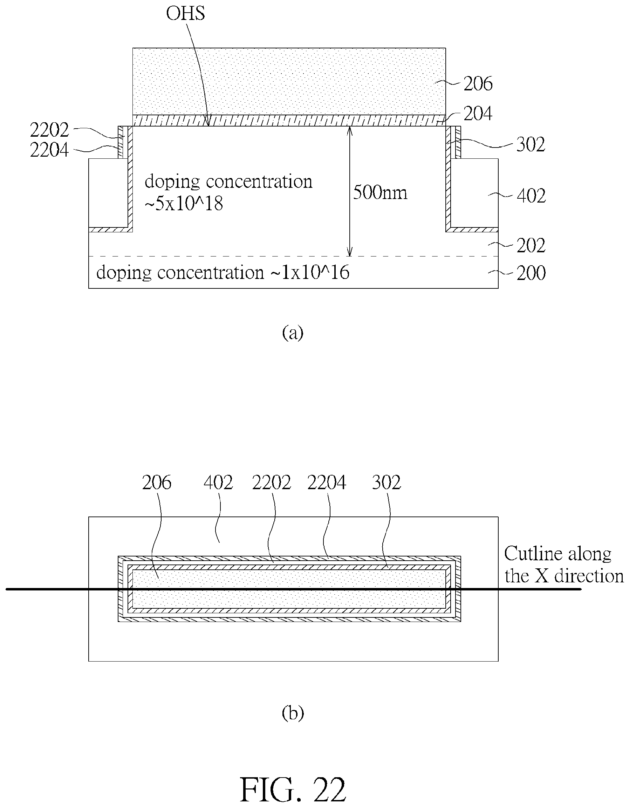

Step 152 (corresponding to FIG. 22) can be referred to Step 106 and Step 108, so further description thereof is omitted for simplicity. In addition, FIG. 22(b) is a top view corresponding to FIG. 22(a), wherein FIG. 22(a) is a cross-section view along a cutline of an X direction shown in FIG. 22(b). In Step 154, as shown in FIG. 22(a), then etch back the STI 402 to remove part of the STI 402 (e.g. 50nm deep from the OHS). This is reserved for future Fin height formation. Then, form the oxide spacer 2202 and the nitride spacer 2204 outside the active region of the SCBFET.

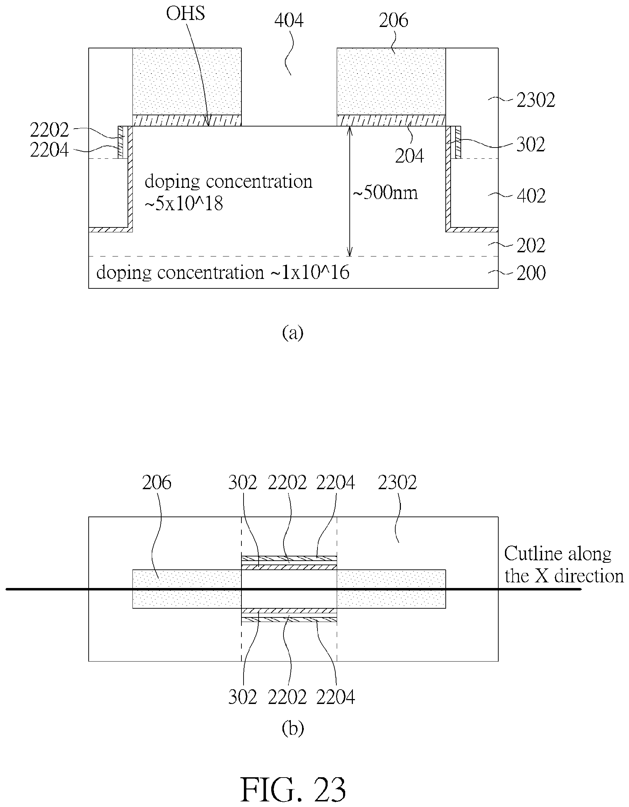

In Step 156, as shown in FIG. 23(a), deposit the thick oxide-2 layer to fully fill the trench 210 and use the CMP technique to remove the excess oxide-2 layer to form the STI oxide-2 2302 above the STI 402, wherein a top surface of the STI oxide-2 2302 is in level up to the top surface of the pad-nitride layer 206.

In Step 158, as shown in FIG. 23(a), differences between Step 158 and Step 110 are that then use the photolithographic masking technique to define the future gate area across the active region and the isolation region so that the pad-oxide layer 204 and the pad-nitride layer 206 corresponding to the gate area are removed, and the STI oxide-2 2302 corresponding to the future gate area is also removed by a certain amount (e.g. 50nm deep). Thus, upper portions of the semiconductor layer 302, the oxide spacer 2202, and the nitride spacer 2204 are exposed. In addition, FIG. 23(b) is a top view corresponding to FIG. 23(a), wherein FIG. 23(a) is a cross-section view along a cutline of an X direction shown in FIG. 23(b)

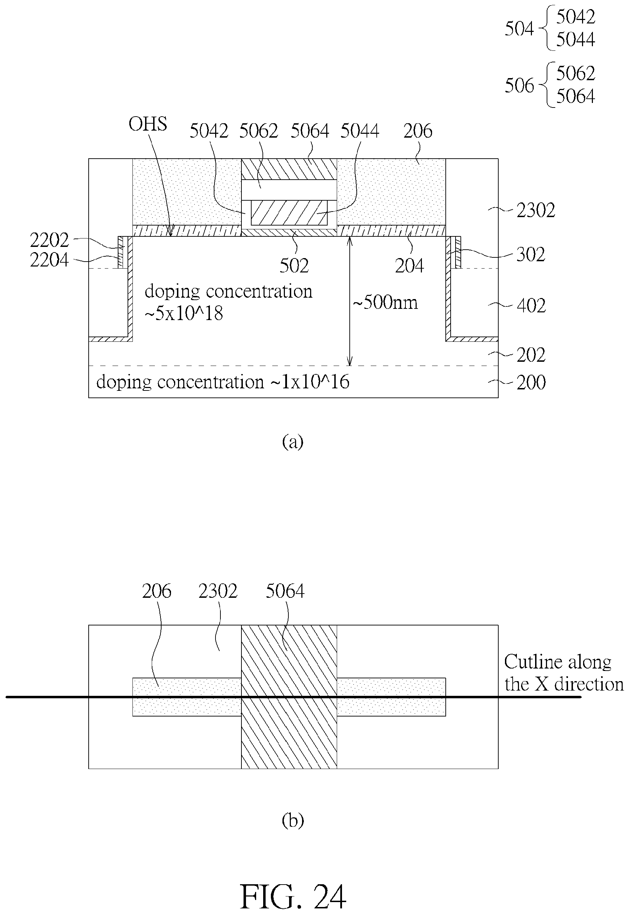

Step 160 and Step 162 (corresponding to FIG. 24) are the same as Step 112 and Step 114, respectively, so further description thereof is omitted for simplicity. In addition, FIG. 24(b) is a top view corresponding to FIG. 24(a), wherein FIG. 24(a) is a cross-section view along a cutline of an X direction shown in FIG. 24(b).

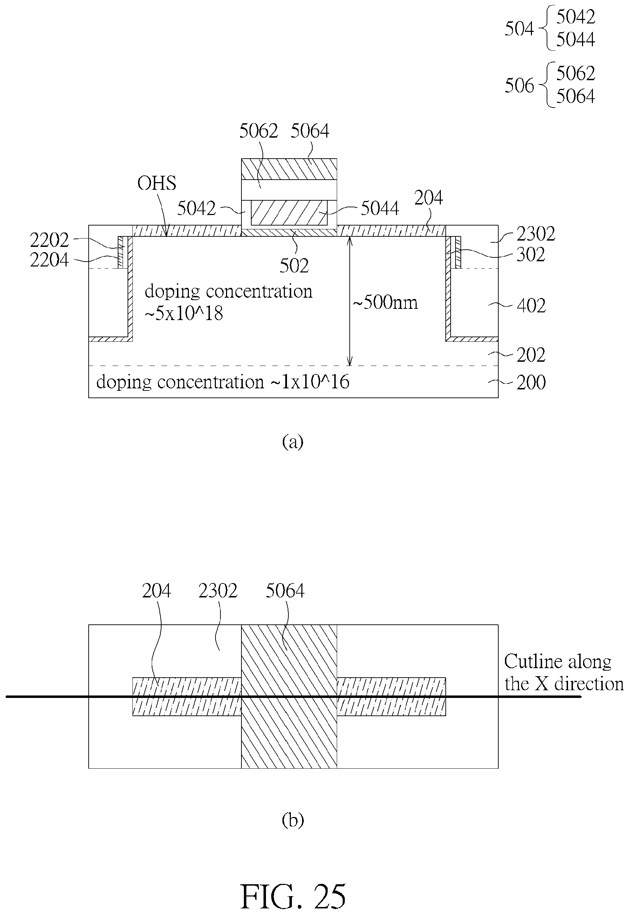

In Step 164, as shown in FIG. 25(a), differences between Step 164 and Step 116 are that etch back the STI oxide-2 2302 and remove the pad-nitride layer 206 to make a top surface of the STI oxide-2 2302 in level up to the top surface of the pad-oxide layer 204. In addition, FIG. 25(b) is a top view corresponding to FIG. 25(a), wherein FIG. 25(a) is a cross-section view along a cutline of an X direction shown in FIG. 25(b).

Similarly, up to Step 164, the two semiconductor layers 302 (sheet-channel layer, SCL) are formed on two sidewalls of the Fin (wherein the two semiconductor layers 302 are named as Qleft and Qright, respectively) but the top surface of the Fin does not have the SCL, so this is the new Type B FinFET (the threshold voltage of the upper MOSFET (Qtop) with higher doping concentrations may be thus higher than those of two sidewall FinFETs). The another embodiment here is to form a Qtop (i.e. forming a SCL on the top area of the Fin). One possible processing method is that before the gate material 504 is patterned (as shown in FIG. 23), remove both the pad-nitride layer 206 and the pad-oxide 204 in a region corresponding to the gate material 504. Then use another SEG to form a thin layer of SCL on the top surface of the Fin (i.e. Qtop). Afterwards, similarly as described in the aforementioned, a thin gate dielectric can be formed at the same time with dielectric formation over the two sidewall SCB layers and the structure is constructed to that described in FIG. 25.

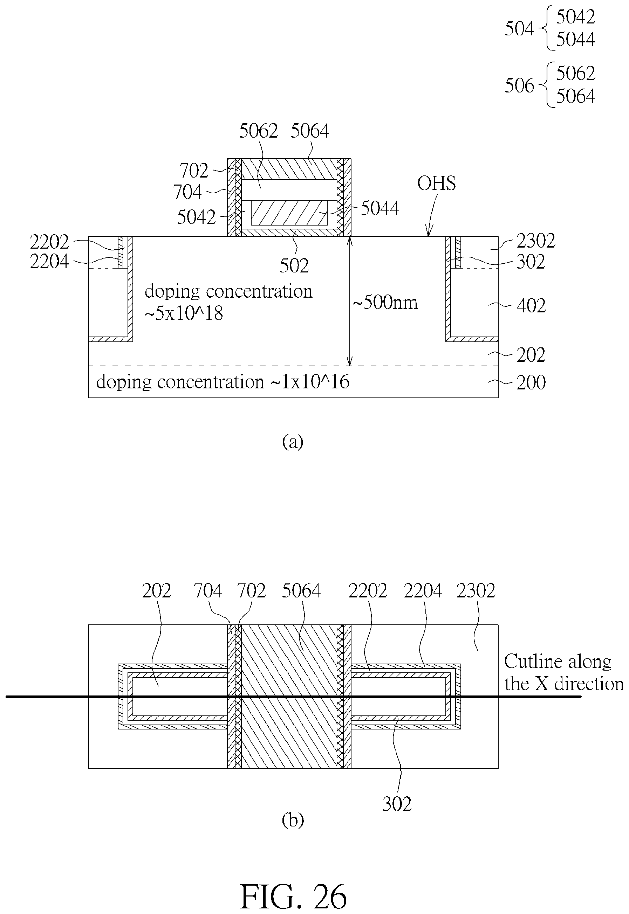

In Step 166, as shown in FIG. 26(a), etch away the pad-oxide layer 204 and then etch back some portion of the STI oxide-2 2302.

Step 168 (corresponding to FIG. 26) is the same as Step 120, so further description thereof is omitted for simplicity. In addition, FIG. 26(b) is a top view corresponding to FIG. 26(a), wherein FIG. 26(a) is a cross-section view along a cutline of an X direction shown in FIG. 26(b).

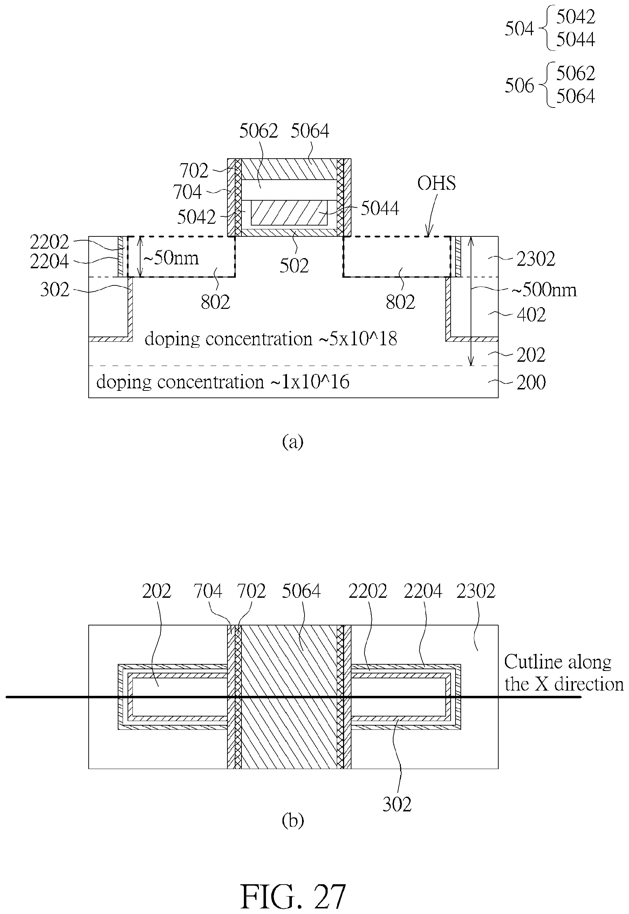

Step 170 (corresponding to FIG. 27) is the same as Step 122, so further description thereof is omitted for simplicity. In addition, FIG. 27(b) is a top view corresponding to FIG. 27(a), wherein FIG. 27(a) is a cross-section view along a cutline of an X direction shown in FIG. 27(b).

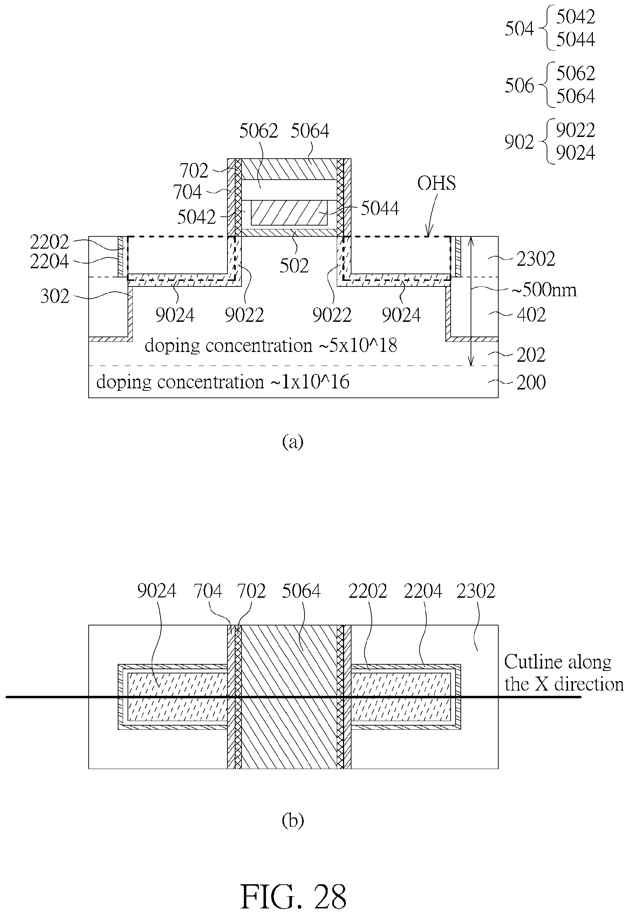

Step 172 (corresponding to FIG. 28) is the same as Step 124, so further description thereof is omitted for simplicity. In addition, FIG. 28(b) is a top view corresponding to FIG. 28(a), wherein FIG. 28(a) is a cross-section view along a cutline of an X direction shown in FIG. 28(b).

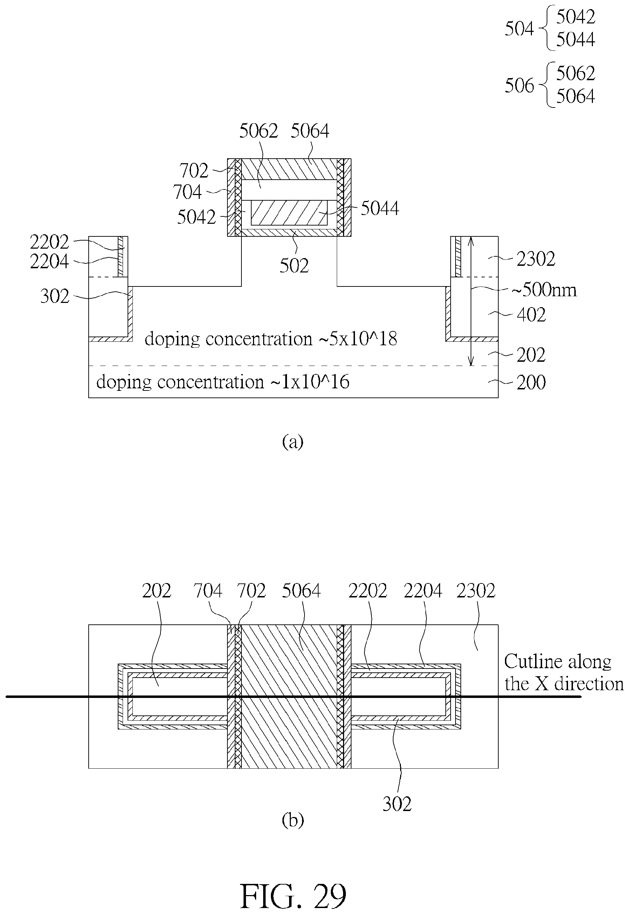

Step 174 (corresponding to FIG. 29) is the same as Step 126, so further description thereof is omitted for simplicity. In addition, FIG. 29(b) is a top view corresponding to FIG. 29(a), wherein FIG. 29(a) is a cross-section view along a cutline of an X direction shown in FIG. 29(b).

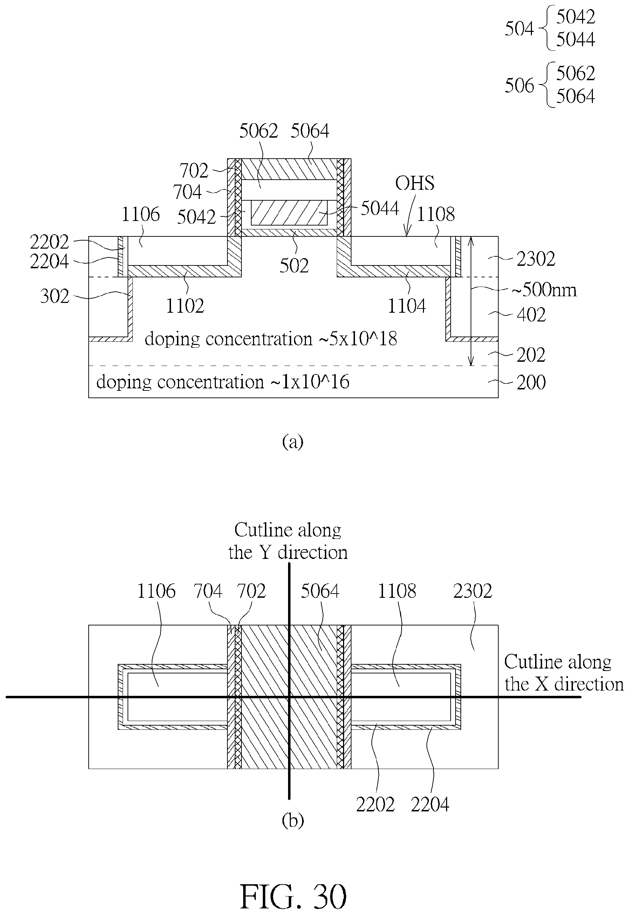

Step 176 (corresponding to FIG. 30) is the same as Step 128, so further description thereof is omitted for simplicity. In addition, FIG. 30(b) is a top view corresponding to FIG. 30(a), wherein FIG. 30(a) is a cross-section view along a cutline of an X direction shown in FIG. 30(b).

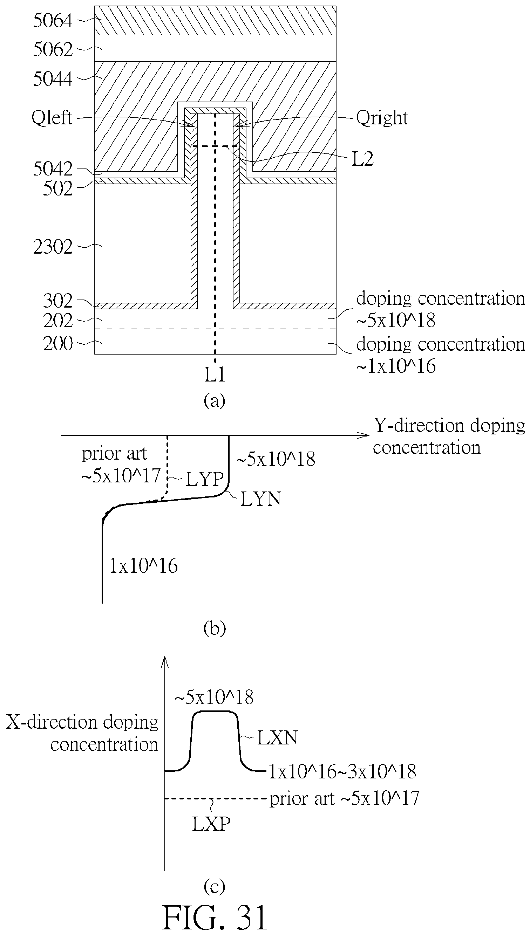

Please refer FIG. 31. FIG. 31(a) is a cross-section view along a cutline of a Y direction shown in FIG. 30(b). As shown in FIG. 31(a), on the cross-section view, it's clear to see both Qleft and Qright SCL layers which are SEG grown p-type doped silicon channel region. As shown in FIG. 31(b), there are Y-direction concentration profile LYN and Y-direction concentration profile LYP of the prior art, wherein the Y-direction concentration profile LYN corresponds to a dash line L1 marked in FIG. 31(a). Similarly, as shown in FIG. 31(c), there is X-direction concentration profile LXN and X-direction concentration profile LXP of the prior art, wherein the X-direction concentration profile LXN corresponds to a dash line L2 marked in FIG. 31(a). It is clear that the doping concentration of the Qleft and the Qright (e.g. 1×10^16 to 3×10^18) is lower than that (e.g. 5×10^18) of the Fin body. The major invention points are described in the following. Since both the drain and the source of the SCBFET are formed by the SEG technique except they are doped with n-type dopants in concentrations higher than that of the Qleft and the Qright, both well-created seamless contact regions between the drain and the channel and between the source and the channel, respectively, have been well formed. No ion-implantations for forming all channel, the drain and the source are completed and no high temperature thermal annealing is necessary to remove those damages due to heavy bombardments of forming the drain and the source. In addition, since the doping contraction of the Qleft and the Qright is lower than that of the bulk body of the SCBFET, it is expected that the threshold voltage be sharply defined by the well-designed work-function of the metal-oxide-SCL structure especially if the concentration of the bulk body is higher and harder to be inverted and a well-defined body voltage (such as Ground) can stabilize the SCBFET function. Then it's believed that the short channel effect of this SCBFET is greatly improved. Moreover, due to heavier doping concentration is used for the SCBFET, the latch-up problems occurring between NMOS and PMOS can also greatly improved.

### Fourth embodiment:

In the following, the fourth embodiment to create a SCBFET is illustrated, wherein the fourth embodiment includes Step 10, Step 20-3, Step 30-3, Step 40-3, Step 50.

Please refer to FIG. 1K and FIGS 2, 3, 32, 33, Step 20-3 could include:

| | |
|---|---|
| Step 102: | Grow a pad-oxide layer 204 and deposit a pad-nitride layer 206. |
| Step 104: | Define active regions of the SCBFET, and remove parts of a silicon material corresponding to the OHS outside the active regions to create trench 210.Step 178: Deposit an oxide layer and use the CMP technique to remove the excess oxide layer to form a shallow trench isolation (STI) 402, and etch back the STI 402. |
| Step 180: | Use the selective epitaxial growth (SEG) technique to grow a semiconductor layer 3302. |

Then, please refer to FIG. 1L and FIGS. 34, 35. Step 30-3 could include:

| | |
|---|---|
| Step 182: | Deposit an oxide-2 layer and use the CMP technique to remove the excess oxide-2 layer to form a STI oxide-2 2302. |
| Step 184: | Define a gate area across the active region and an isolation region, etch away the pad-oxide layer 204, the pad-nitride layer 206, and etch back the STI oxide-2 2302 corresponding to the gate area. |
| Step 186: | Form a gate dielectric material 502 and deposit a gate material 504 in a concave 404, and then the gate material 504 is polished by the CMP technique and etch back the gate material 504. |
| Step 188: | Form a composite cap layer 506 and polish the composite cap layer 506 by the CMP technique. |

Please refer to FIG. 1M, FIGS. 36, 37, 38, 39, 40, 41, 42. Step 40-3 could include:

| | |
|---|---|
| Step 190: | Etch back the STI oxide-2 2302 and remove the pad-nitride layer 206. |
| Step 192: | Etch away the pad-oxide layer 204 and then etch back the STI oxide-2 2302. |
| Step 194: | Form an oxide-2 spacer 702 and a nitride-2 spacer 704 on edges of the gate material 504 and the composite cap layer 506. |
| Step 195: | Etch away exposed silicon. |
| Step 196: | Grow thermally an oxide-3 layer 902. |
| Step 197: | Etch away the oxide-3 layer 902. |
| Step 198: | Form n-type lightly doped drains (LDDs) 1102, 1104 and then form n+ doped source 1106 and n+ doped drain 1108. |

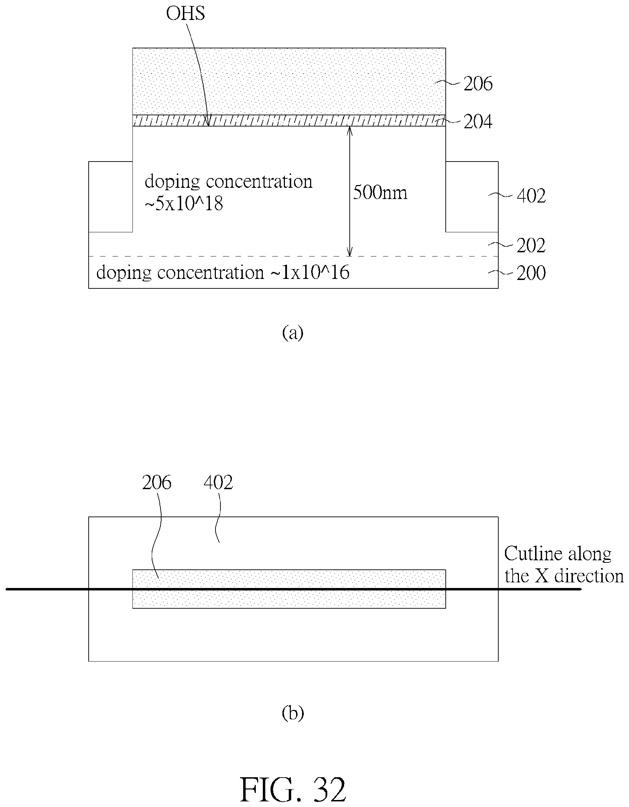

In Step 178, as shown in FIG. 32(a), deposit the thick oxide layer into the trench 210 and use the CMP technique to remove the excess oxide layer to form the STI 402, wherein meanwhile the top surface of the STI 402 is in level up to the top surface of the pad-nitride layer 206. In addition, it is noted that no sheet-channel layer (SCL) is grown in the trench 210. Then, etch back the STI 402 to remove part of the STI 402 (e.g. 50nm deep from the OHS). This is reserved for future Fin height formation. In addition, FIG. 32(b) is a top view corresponding to FIG. 32(a), wherein FIG. 32(a) is a cross-section view along a cutline of an X direction shown in FIG. 32(b).

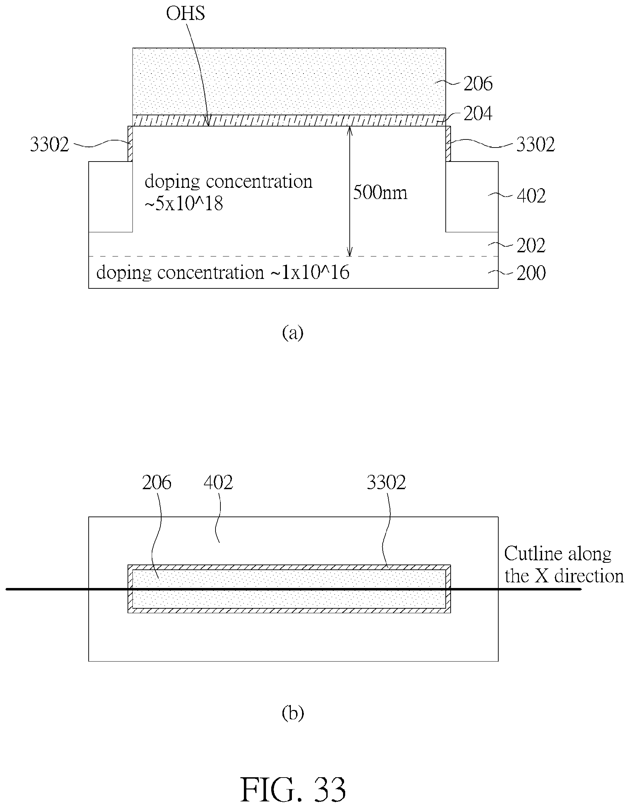

In Step 180, as shown in FIG. 33(a), use the selective epitaxial growth (SEG) technique to grow the semiconductor layer 3302 (i.e. sheet-channel layer, SCL) of monolithic p-type doped silicon (e.g. about 1 to 2 nm thickness which should be well adjusted for detailed device design) over the exposed silicon surfaces (two sidewalls of the Fin structure). In addition, operational principles of the semiconductor layer 3302 are the same as the semiconductor layer 302, so further description thereof is omitted for simplicity. In addition, FIG. 33(b) is a top view corresponding to FIG. 33(a), wherein FIG. 33(a) is a cross-section view along a cutline of an X direction shown in FIG. 33(b).

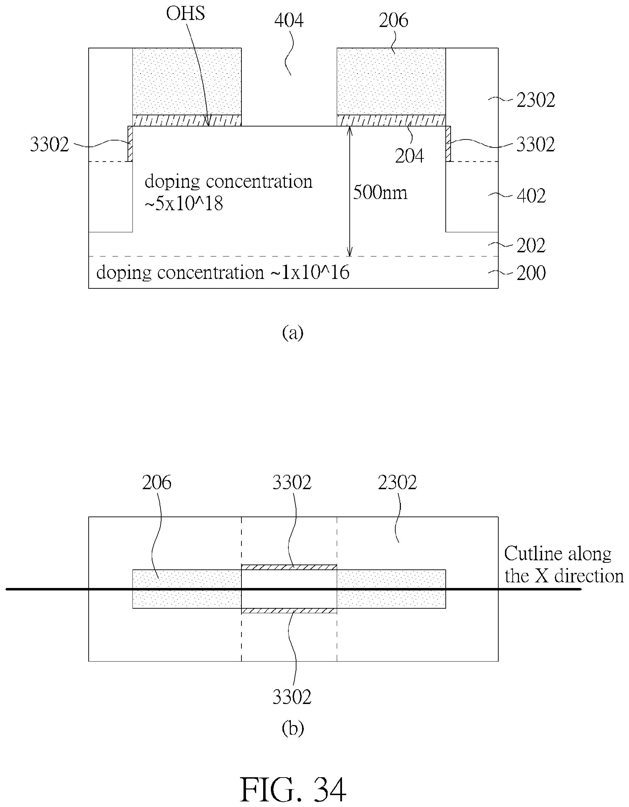

In Step 182, as shown in FIG. 34(a), deposit the thick oxide-2 layer to fully fill the trench 210 and use the CMP technique to remove the excess oxide-2 layer to form the STI oxide-2 2302 above the STI 402, wherein the top surface of the STI oxide-2 2302 is in level up to the top surface of the pad-nitride layer 206.

In Step 184, as shown in FIG. 34(a), then use the photolithographic masking technique to define the future gate area across the active region and the isolation region so that the pad-oxide layer 204 and the pad-nitride layer 206 corresponding to the gate area are removed, and the STI oxide-2 2302 corresponding to the future gate area is also removed by a certain amount (e.g. 50nm deep). Thus, the upper portion of the semiconductor layer 3302 is exposed. In addition, FIG. 34(b) is a top view corresponding to FIG. 34(a), wherein FIG. 34(a) is a cross-section view along a cutline of an X direction shown in FIG. 34(b).

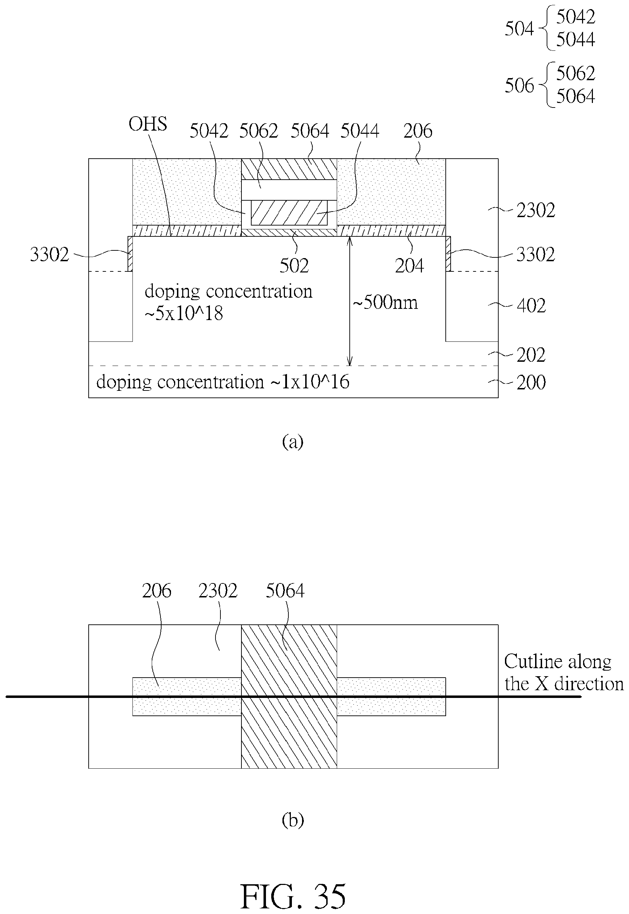

Step 186 and Step 188 (corresponding to FIG. 35) are the same as Step 112 and Step 114, respectively, so further description thereof is omitted for simplicity. In addition, FIG. 35(b) is a top view corresponding to FIG. 35(a), wherein FIG. 35(a) is a cross-section view along a cutline of an X direction shown in FIG. 35(b).

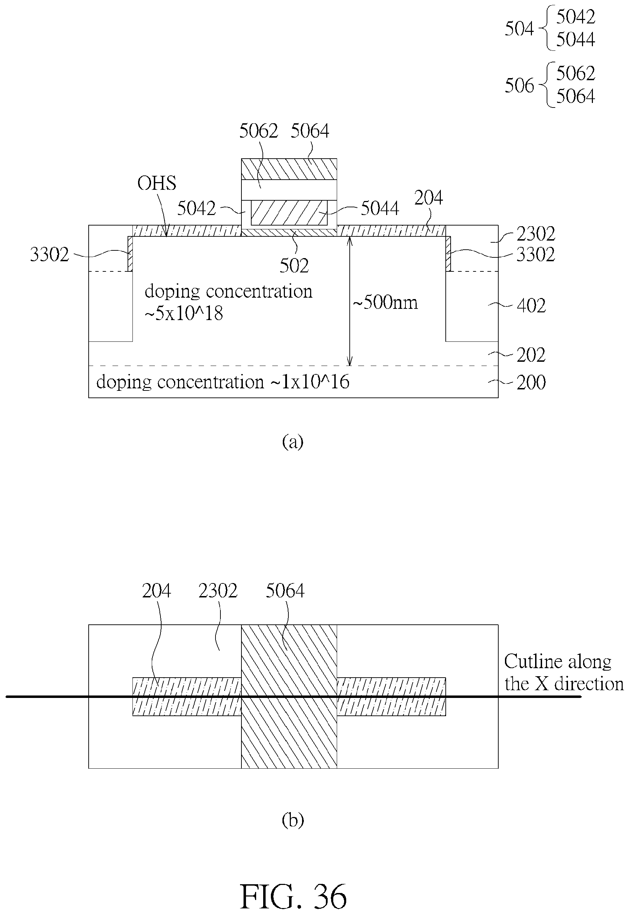

In Step 190, as shown in FIG. 36(a), differences between Step 190 and Step 116 are that etch back the STI oxide-2 2302 and remove the pad-nitride layer 206 to make the top surface of the STI oxide-2 2302 in level up to the top surface of the pad-oxide layer 204. In addition, FIG. 36(b) is a top view corresponding to FIG. 36(a), wherein FIG. 36(a) is a cross-section view along a cutline of an X direction shown in FIG. 36(b).

Similarly, up to Step 190, the two semiconductor layers 3302 (sheet-channel layer, SCL) are formed on two sidewalls of the Fin (wherein the two semiconductor layers 3302 are named as Qleft and Qright, respectively) but the top surface of the Fin does not have the SCL, so this is the new Type B FinFET (the threshold voltage of the upper MOSFET (Qtop) with higher doping concentrations may be thus higher than those of two sidewall FinFETs). The another embodiment here is to form a Qtop (i.e. forming a SCL on the top area of the Fin). One possible processing method is that before the gate material 504 is patterned (as shown in FIG. 34), remove both the pad-nitride layer 206 and the pad-oxide 204 in a region corresponding to the gate material 504. Then use another SEG to form a thin layer of SCL on the top surface of the Fin (i.e. Qtop). Afterwards, similarly as described in the aforementioned, a thin gate dielectric can be formed at the same time with dielectric formation over the two sidewall SCB layers and the structure is constructed to that described in FIG. 35.

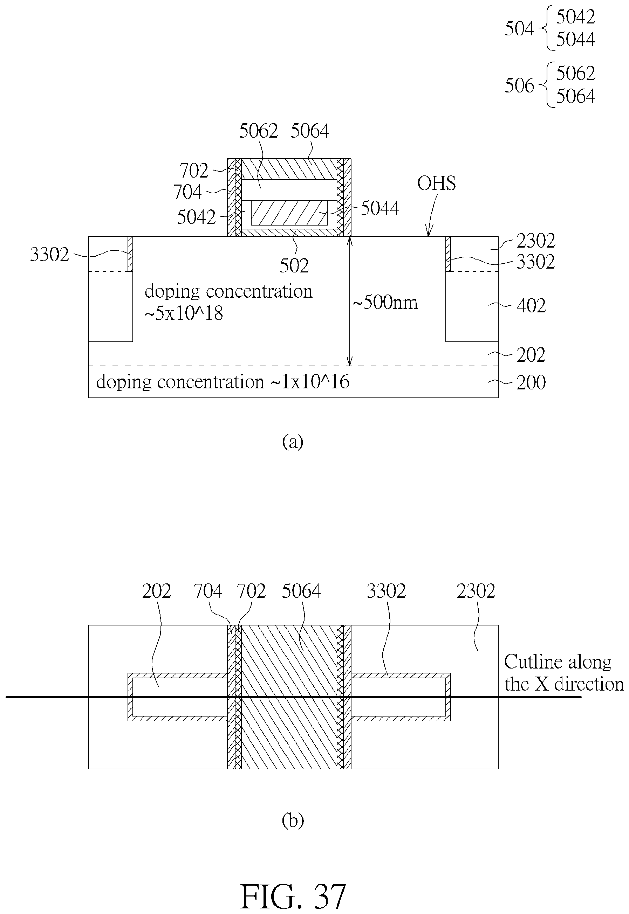

In Step 192, as shown in FIG. 37(a), etch away the pad-oxide layer 204 and then etch back some portion of the STI oxide-2 2302.

Step 194 (corresponding to FIG. 37) is the same as Step 120, so further description thereof is omitted for simplicity. In addition, FIG. 37(b) is a top view corresponding to FIG. 37(a), wherein FIG. 37(a) is a cross-section view along a cutline of an X direction shown in FIG. 37(b).

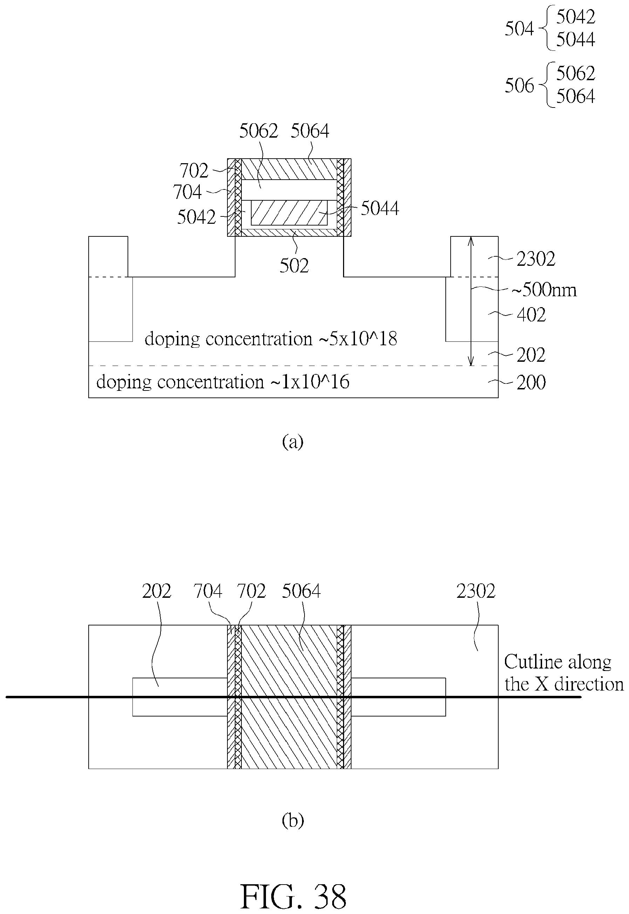

Step 195 (corresponding to FIG. 38) is the same as Step 122, so further description thereof is omitted for simplicity. In addition, FIG. 38(b) is a top view corresponding to FIG. 38(a), wherein FIG. 38(a) is a cross-section view along a cutline of an X direction shown in FIG. 38(b).

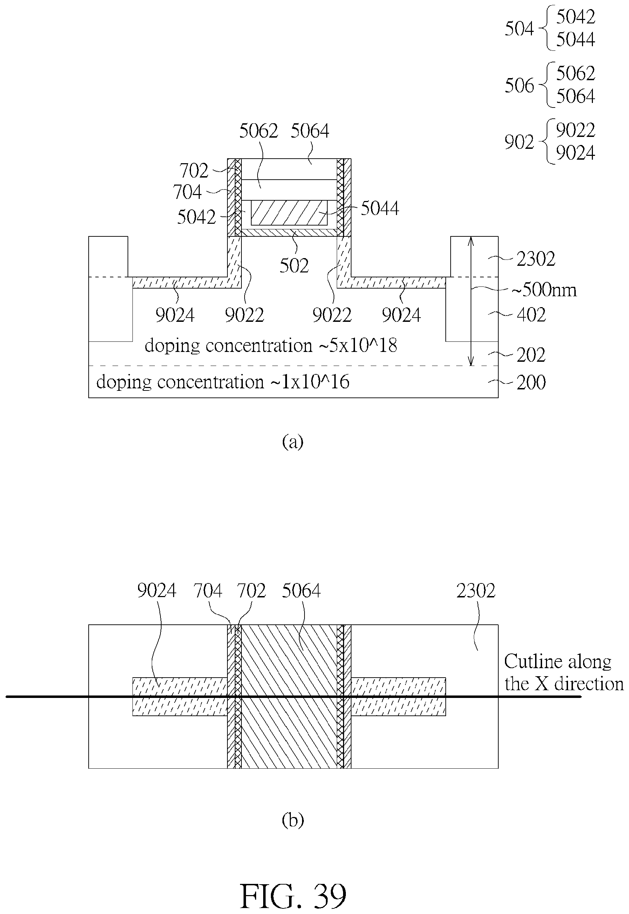

Step 196 (corresponding to FIG. 39) is the same as Step 124, so further description thereof is omitted for simplicity. In addition, FIG. 39(b) is a top view corresponding to FIG. 39(a), wherein FIG. 39(a) is a cross-section view along a cutline of an X direction shown in FIG. 39(b).

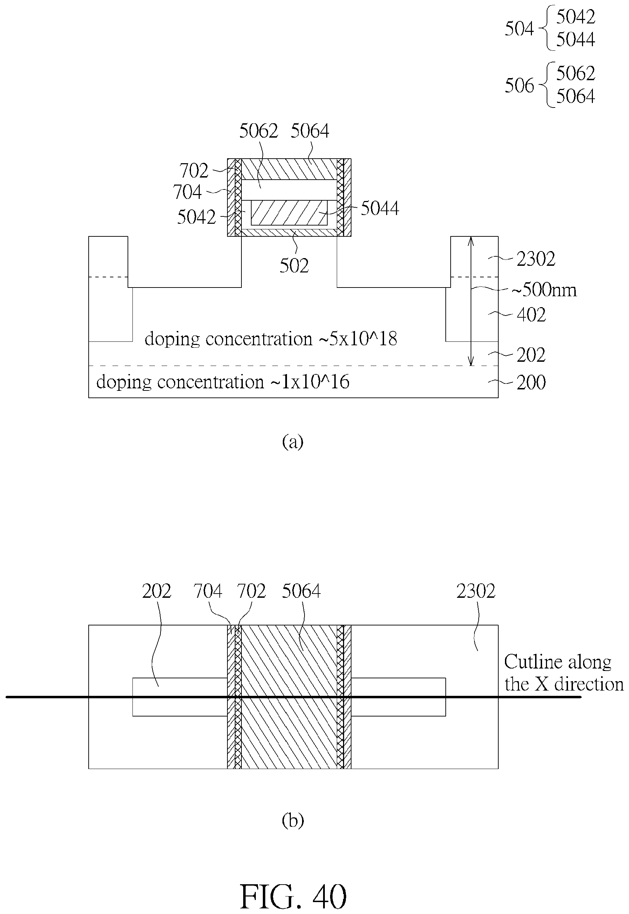

Step 197 (corresponding to FIG. 40) is the same as Step 126, so further description thereof is omitted for simplicity. In addition, FIG. 40(b) is a top view corresponding to FIG. 40(a), wherein FIG. 40(a) is a cross-section view along a cutline of an X direction shown in FIG. 40(b).

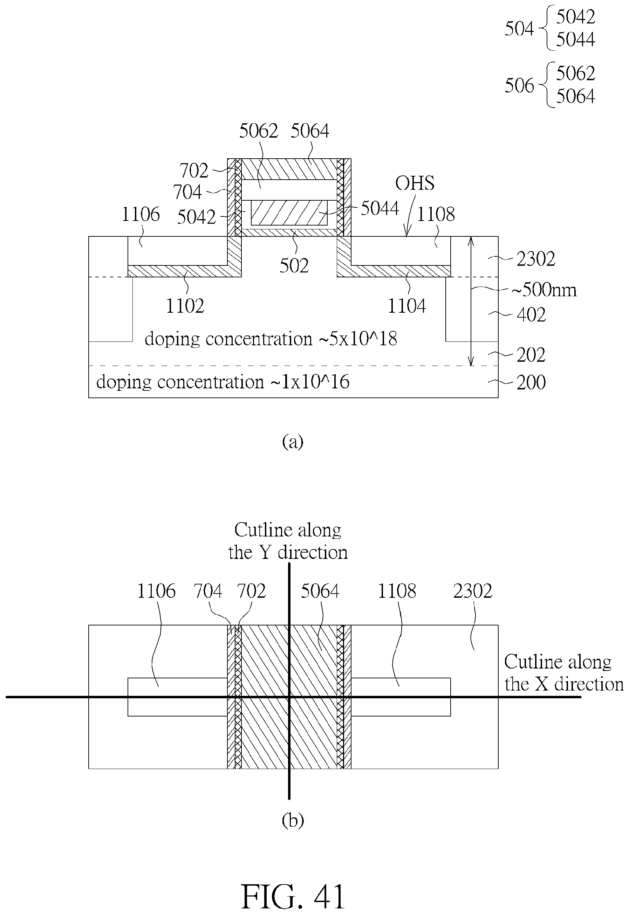

Step 198 (corresponding to FIG. 41) is the same as Step 128, so further description thereof is omitted for simplicity. In addition, FIG. 41(b) is a top view corresponding to FIG. 41(a), wherein FIG. 41(a) is a cross-section view along a cutline of an X direction shown in FIG. 41(b).

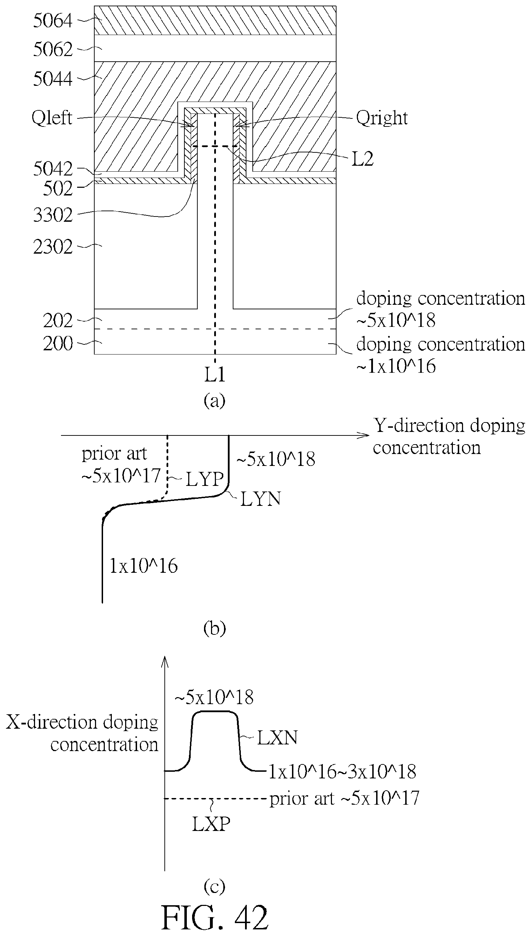

Please refer FIG. 42. FIG. 42(a) is a cross-section view along a cutline of a Y direction shown in FIG. 41(b). As shown in FIG. 42(a), on the cross-section view, it's clear to see both the Qleft and the Qright which are SEG grown p-type doped silicon channel region. As shown in FIG. 42(b), there are Y-direction concentration profile LYN and Y-direction concentration profile LYP of the prior art, wherein the Y-direction concentration profile LYN corresponds to a dash line L1 marked in FIG. 42(a). Similarly, as shown in FIG. 42(c), there is X-direction concentration profile LXN and X-direction concentration profile LXP of the prior art, wherein the X-direction concentration profile LXN corresponds to a dash line L2 marked in FIG. 42(a). It is clear that the doping concentration of the Qleft and the Qright (e.g. 1×10^16 to 3×10^18) is lower than that (e.g. 5×10^18) of the Fin body. The major invention points are described in the following. Since both the drain and the source of the SCBFET are formed by the SEG technique except they are doped with n-type dopants in concentrations higher than that of the Qleft and the Qright, both well-created seamless contact regions between the drain and the channel and between the source and the channel, respectively, have been well formed. No ion-implantations for forming all channels, the drain and the source are completed and no high temperature thermal annealing is necessary to remove those damages due to heavy bombardments of forming the drain and the source. In addition, since the doping contraction of the Qleft and the Qright is lower than that of the bulk body of the SCBFET, it is expected that the threshold voltage be sharply defined by the well-designed work-function of the metal-oxide-SCL structure especially if the concentration of the bulk body is higher and harder to be inverted and a well-defined body voltage (such as Ground) can stabilize the SCBFET function. Then it's believed that the short channel effect of the SCBFET is greatly improved. Moreover, due to heavier doping concentration is used for the SCBFET, the latch-up problems occurring between NMOS and PMOS can also greatly improved.

## Claims

1. A transistor structure comprising:
a substrate with a body region;
a gate conductive region above the body region;
a gate dielectric layer between the gate conductive region and the body region; and **characterized by**:
a sheet channel layer disposed between the body region and the gate dielectric layer, wherein the sheet channel layer is independent from the substrate;
wherein a doping concentration of the body region is higher than a doping concentration of the sheet channel layer.

2. The transistor structure in claim 1, further **characterized in that** the substrate further comprises a well region underneath the body region, and the doping concentration of the sheet channel layer is higher than a doping concentration of the well region.

3. The transistor structure in claim 1, further **characterized in that** the body region comprises a fin structure and the sheet channel layer comprises a first sheet channel layer and a second sheet channel layer, the first sheet channel layer contacts to a first sidewall of the fin structure, and the second sheet channel layer contacts to a second sidewall of the fin structure.

4. The transistor structure in claim 3, further **characterized in that** the sheet channel layer further comprises a third sheet channel layer directly on a top wall of the fin structure.

5. The transistor structure in claim 3, further **characterized by** a spacer layer attaching to the first sheet channel layer and the second sheet channel layer.

6. The transistor structure in claim 5, further **characterized in that** the spacer layer comprises a nitride layer.

7. The transistor structure in claim 5, further **characterized in that** further the spacer layer only attaches to an upper portion of the first sheet channel layer and an upper portion of the second sheet channel layer.

8. The transistor structure in claim 3, further **characterized in that** the first sheet channel layer only contacts to an upper portion of the first side wall of the fin structure, and the second sheet channel layer only contacts to an upper portion of the second side wall of the fin structure.

9. The transistor structure in claim 1, further **characterized by** a first conductive region abutting against the sheet channel layer and the body region, wherein the first conductive region is independent from the substrate.

10. The transistor structure in claim 9, further **characterized in that** the first conductive region comprises a lightly doped region and a highly doped region vertically stacked on the lightly doped region.

11. The transistor structure in claim 10, further **characterized in that** the lightly doped region and the highly doped region are formed by selective growth.

12. The transistor structure in claim 1, further **characterized in that** the sheet channel layer is formed by selective growth.
